# EUROPEAN PATENT APPLICATION

(11) **EP 4 848 271 A1**
(43) Date of publication of application: **02.12.2026**
(21) Application number: 24951604.8
(22) Date of filing: 22.08.2024
(51) Int. Cl.: G09G 3/3266

(54) **SHIFT REGISTER UNIT AND DRIVING METHOD THEREFOR, AND DISPLAY DRIVE CIRCUIT AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Daxing District Beijing 100176 (CN)
(72) Inventor: DONG, Xiangdan, Beijing 100176 (CN); HUANG, Yao, Beijing 100176 (CN); WANG, Rong, Beijing 100176 (CN); DU, Mengmeng, Beijing 100176 (CN)
(74) Representative: Haseltine Lake Kempner LLP
(86) International application number: PCT/CN2024/113897
(87) International publication number: WO 2026/040041

(57) **Abstract**

Provided are a shift register unit and a driving method therefor, and a display drive circuit and a display apparatus, which belong to the technical field of display. In the shift register unit, an input circuit can control, in response to a clock signal, an input terminal to transmit a signal to a first node, and can control, in response to the potential of the first node, a first power supply terminal and a second power supply terminal to respectively transmit a power supply signal to a second node within different time periods; and an output circuit can control, in response to the potential of the second node or the potentials of the first node and the second node, the first power supply terminal and a third power supply terminal to respectively transmit a power supply signal to a first output terminal within different time periods. Therefore, it can be determined that the shift register unit comprises both a P-type transistor and an N-type transistor. Accordingly, it can be known that on the basis of a design featuring a simple structure and a simple driving principle, the shift register unit can output a required driving signal to pixels. Moreover, due to the simple structure, a narrow-bezel design of a display apparatus can also be facilitated.

## Description

### TECHNICAL FIELD

This application relates to the field of display technologies, and specifically relates to a shift register unit, a driving method thereof, a display driving circuit, and a display device.

### BACKGROUND

With the development of display technologies, a Gate Drive on Array (GOA) technology may be used to integrate a display driving circuit (e.g., a gate driver circuit) for driving pixels to emit light on a substrate of a display device. Correspondingly, the display driving circuit may also be referred to as a GOA circuit.

Currently, a GOA circuit generally includes a plurality of cascade-connected GOA units (also referred to as shift register units). The plurality of GOA units are connected in one-to-one correspondence to a plurality of rows of pixels in the display device, and are configured to transmit required display driving signals row by row to the plurality of rows of pixels to drive the plurality of rows of pixels to emit light row by row. For example, in a scenario where the display driving circuit is a gate driver circuit, the display driving circuit may be connected in one-to-one correspondence to the plurality of rows of pixels through a plurality of gate lines, and is configured to transmit gate driving signals row by row to the plurality of rows of pixels through the plurality of gate lines.

However, current GOA units are mostly all-P-type or all-N-type structured circuits, which have complex structures, complicated driving principles, and cannot be conducive to a narrow bezel design of the display device.

### SUMMARY

A shift register unit, a driving method thereof, a display driving circuit and a display device are provided. The technical solution is as follows.

In one aspect, a shift register unit is provided. The shift register unit includes:
a first input circuit, connected to a first clock terminal, an input terminal, and a first node, respectively, and configured to control switching on and off of a connection between the input terminal and the first node in response to a first clock signal provided by the first clock terminal;
a second input circuit, connected to the first node, a first power supply terminal, a second power supply terminal, and a second node, respectively, and configured to control switching on and off of a connection between the first power supply terminal and the second node and control switching on and off of a connection between the second power supply terminal and the second node in response to a potential of the first node, wherein the first power supply terminal and the second power supply terminal are switched on to the second node in different time periods, respectively; and
a first output circuit, connected to the second node, a first target node, the first power supply terminal, a third power supply terminal, and a first output terminal, respectively, and configured to control switching on and off of a connection between the first power supply terminal and the first output terminal in response to a potential of the second node, and control switching on and off of a connection between the third power supply terminal and the first output terminal in response to a potential of the first target node, wherein the first power supply terminal and the third power supply terminal are switched on to the first output terminal in different time periods, respectively; and wherein the first target node is shared as the first node or the second node.

Optionally, the second power supply terminal is shared as the third power supply terminal;
or, the second power supply terminal and the third power supply terminal are independent of each other, and a potential of a second power supply signal provided by the second power supply terminal is less than a potential of a third power supply signal provided by the third power supply terminal.

Optionally, the first input circuit includes: a first transistor; wherein the first transistor is a P-type transistor; and
a gate of the first transistor is connected to the first clock terminal, a first electrode of the first transistor is connected to the input terminal, and a second electrode of the first transistor is connected to the first node.

Optionally, the second input circuit includes: a second transistor and a third transistor; wherein the second transistor and the third transistor are a P-type transistor and an N-type transistor, respectively;
a gate of the second transistor is connected to the first node, a first electrode of the second transistor is connected to the first power supply terminal, and a second electrode of the second transistor is connected to the second node; and
a gate of the third transistor is connected to the first node, a first electrode of the third transistor is connected to the second power supply terminal, and a second electrode of the third transistor is connected to the second node.

Optionally, the first output circuit includes: a fourth transistor and a fifth transistor; wherein the fourth transistor and the fifth transistor are both P-type transistors, or are an N-type transistor and a P-type transistor, respectively;
a gate of the fourth transistor is connected to the first target node, a first electrode of the fourth transistor is connected to the third power supply terminal, and a second electrode of the fourth transistor is connected to the first output terminal; and
a gate of the fifth transistor is connected to the second node, a first electrode of the fifth transistor is connected to the first power supply terminal, and a second electrode of the fifth transistor is connected to the first output terminal.

Optionally, the second input circuit is further connected to a third node, and is configured to control switching on and off of a connection between the first power supply terminal and the third node in response to a potential of the first node; and the shift register unit further includes:
a third input circuit, connected to the third node, a second clock terminal, and the second node, respectively, and configured to control switching on and off of a connection between the second clock terminal and the second node in response to a potential of the third node, and regulate a potential of the third node based on a second clock signal provided by the second clock terminal.

Optionally, the second input circuit further includes: a sixth transistor; wherein the sixth transistor is a P-type transistor; and
a gate of the sixth transistor is connected to the first node, a first electrode of the sixth transistor is connected to the first power supply terminal, and a second electrode of the sixth transistor is connected to the third node.

Optionally, the third input circuit includes: a seventh transistor and a first capacitor; wherein the seventh transistor is a P-type transistor;
a gate of the seventh transistor is connected to the third node, a first electrode of the seventh transistor is connected to the second clock terminal, and a second electrode of the seventh transistor is connected to the second node; and
one terminal of the first capacitor is connected to the third node, and the other terminal of the first capacitor is connected to the second clock terminal.

Optionally, the first node includes: a first sub-node and a second sub-node; and the shift register unit further includes:
a first control circuit, connected to the third power supply terminal, the first sub-node, and the second sub-node, respectively, and configured to control switching on and off of a connection between the first sub-node and the second sub-node in response to a third power supply signal provided by the third power supply terminal;
and, the first input circuit is connected to the first sub-node, and configured to control switching on and off of a connection between the input terminal and the first sub-node in response to the first clock signal;
the second input circuit is connected to the first sub-node and the second sub-node, respectively, and configured to control switching on and off of a connection between the first power supply terminal and the second node and control switching on and off of a connection between the first power supply terminal and the third node in response to a potential of the first sub-node, and control switching on and off of a connection between the second power supply terminal and the second node in response to a potential of the second sub-node; or, in a case where the first target node is shared as the first node, the second input circuit is connected to the first sub-node, and configured to control switching on and off of a connection between the first power supply terminal and the second node, control switching on and off of a connection between the second power supply terminal and the second node, and control switching on and off of a connection between the first power supply terminal and the third node in response to the potential of the first sub-node; and the first output circuit is connected to the second sub-node, and configured to control switching on and off of a connection between the third power supply terminal and the first output terminal in response to the potential of the second sub-node.

Optionally, the first control circuit includes: an eighth transistor; wherein the eighth transistor is a P-type transistor; and
a gate of the eighth transistor is connected to the third power supply terminal, a first electrode of the eighth transistor is connected to the first sub-node, and a second electrode of the eighth transistor is connected to the second sub-node.

Optionally, the first output terminal is configured to be connected to an input terminal of another cascade-connected shift register unit and a pixel, respectively;
or, the first output terminal is configured to be connected to an input terminal of another cascade-connected shift register unit, and the shift register unit further includes:
a second output circuit, connected to the first output terminal, a second target node, a third clock terminal, a fourth power supply terminal, and a second output terminal, respectively, and configured to control switching on and off of a connection between the third clock terminal and the second output terminal in response to a signal output via the first output terminal, and control switching on and off of a connection between the fourth power supply terminal and the second output terminal in response to a potential of the second target node, wherein the third clock terminal and the fourth power supply terminal are switched on to the second output terminal in different time periods, respectively; wherein the second output terminal is configured to be connected to a pixel; and the second target node is shared as the first node connected to the first output circuit or the second node connected to the first output circuit.

Optionally, the fourth power supply terminal is shared as the third power supply terminal;
or, the fourth power supply terminal and the third power supply terminal are independent of each other, and a potential of a fourth power supply signal provided by the fourth power supply terminal is less than a potential of a third power supply signal provided by the third power supply terminal.

Optionally, the second output circuit includes: a ninth transistor and a tenth transistor; wherein the ninth transistor and the tenth transistor are a P-type transistor and an N-type transistor, respectively;
a gate of the ninth transistor is connected to the first output terminal, a first electrode of the ninth transistor is connected to the third clock terminal, and a second electrode of the ninth transistor is connected to the second output terminal; and
a gate of the tenth transistor is connected to the second target node, a first electrode of the tenth transistor is connected to the fourth power supply terminal, and a second electrode of the tenth transistor is connected to the second output terminal.

Optionally, the shift register unit further includes:
a second control circuit, connected between the first output terminal and the second output circuit, and further connected to the third power supply terminal, and configured to control switching on and off of a connection between the first output terminal and the second output circuit in response to a third power supply signal provided by the third power supply terminal.

Optionally, the second control circuit includes: an eleventh transistor; wherein the eleventh transistor is a P-type transistor; and
a gate of the eleventh transistor is connected to the third power supply terminal, a first electrode of the eleventh transistor is connected to the first output terminal, and a second electrode of the eleventh transistor is connected to the second output circuit.

Optionally, the shift register unit further includes at least one circuit of the following circuits:
a first potential regulation circuit, connected to the first target node and the first output terminal, respectively, and configured to regulate a potential of the first target node based on a signal output via the first output terminal, wherein the first target node is shared as the first node;
a second potential regulation circuit, connected to the second node and the first power supply terminal, respectively, and configured to regulate a potential of the second node based on a first power supply signal provided by the first power supply terminal; or
a third potential regulation circuit, connected to a target signal terminal and a connection node between the second control circuit and the second output circuit, respectively, and configured to regulate a potential of the connection node based on a signal provided by the target signal terminal; wherein, in a case where the second target node is shared as the first node, the target signal terminal is the third clock terminal or the second output terminal; and in a case where the second target node is shared as the second node, the target signal terminal is the second output terminal.

Optionally, the first potential regulation circuit includes a second capacitor; the second potential regulation circuit includes a third capacitor; and the third potential regulation circuit includes a fourth capacitor; wherein
one terminal of the second capacitor is connected to the first target node, and the other terminal of the second capacitor is connected to the first output terminal;
one terminal of the third capacitor is connected to the second node, and the other terminal of the third capacitor is connected to the first power supply terminal; and
one terminal of the fourth capacitor is connected to the connection node, and the other terminal of the fourth capacitor is connected to the target signal terminal.

In another aspect, a driving method of a shift register unit is provided, and the driving method is used for driving the shift register unit as described in the above aspect. The method includes:
during an input phase, controlling, by the first input circuit, a connection between the input terminal and the first node to be switched on in response to a first clock signal provided by the first clock terminal, controlling, by the second input circuit, a connection between the first power supply terminal and the second node to be switched on and a connection between the second power supply terminal and the second node to be switched off in response to a potential of the first node, and, controlling, by the first output circuit, a connection between the first power supply terminal and the first output terminal to be switched off in response to a potential of the second node, and a connection between the third power supply terminal and the first output terminal to be switched on in response to a potential of a first target node; wherein the first target node is shared as the first node or the second node; and
during an output phase, controlling, by the first input circuit, a connection between the input terminal and the first node to be switched on in response to the first clock signal, controlling, by the second input circuit, a connection between the first power supply terminal and the second node to be switched off and a connection between the second power supply terminal and the second node to be switched on in response to the potential of the first node, and, controlling, by the first output circuit, a connection between the first power supply terminal and the first output terminal to be switched on in response to the potential of the second node, and a connection between the third power supply terminal and the first output terminal to be switched off in response to the potential of the first target node.

Optionally, the first output terminal is configured to be connected to an input terminal of another cascade-connected shift register unit and a pixel, respectively; or, the first output terminal is configured to be connected to the input terminal of another cascade-connected shift register unit, and the shift register unit further includes: a second output circuit; and the method further includes:
during the input phase, controlling, by the second output circuit, a connection between the third clock terminal and a second output terminal to be switched on in response to a signal output via the first output terminal, and a connection between a fourth power supply terminal and the second output terminal to be switched off in response to a potential of a second target node; wherein the second output terminal is configured to be connected to the pixel; and the second target node is shared as the first node connected to the first output circuit or the second node connected to the first output circuit; and
during the output phase, controlling, by the second output circuit, a connection between the third clock terminal and the second output terminal to be switched off in response to the signal output via the first output terminal, and a connection between the fourth power supply terminal and the second output terminal to be switched on in response to the potential of the second target node.

In yet another aspect, a display driving circuit is provided. The display driving circuit includes at least two cascade-connected shift register units as described in the above aspect.

In still another aspect, a display device is provided. The display device includes: a display panel, and the display driving circuit as described in the above aspect; wherein
the display panel includes a plurality of pixels, the display driving circuit is connected to the plurality of pixels, and the display driving circuit is configured to transmit display driving signals to the plurality of pixels to drive the plurality of pixels to emit light.

### BRIEF DESCRIPTION OF DRAWINGS

To describe the technical solutions in the embodiments of this application more clearly, the following briefly introduces the accompanying drawings required for describing the embodiments. Obviously, the accompanying drawings in the following description show merely some embodiments of this application. For a person of ordinary skill in the art, other accompanying drawings may be derived from these accompanying drawings without creative effort.
FIG. 1 is a structural schematic diagram of a shift register unit according to an embodiment of this application;
FIG. 2 is a structural schematic diagram of another shift register unit according to an embodiment of this application;
FIG. 3 is a structural schematic diagram of yet another shift register unit according to an embodiment of this application;
FIG. 4 is a structural schematic diagram of still another shift register unit according to an embodiment of this application;
FIG. 5 is a structural schematic diagram of a further shift register unit according to an embodiment of this application;
FIG. 6 is a structural schematic diagram of a further shift register unit according to an embodiment of this application;
FIG. 7 is a structural schematic diagram of a further shift register unit according to an embodiment of this application;
FIG. 8 is a structural schematic diagram of a further shift register unit according to an embodiment of this application;
FIG. 9 is a structural schematic diagram of a further shift register unit according to an embodiment of this application;
FIG. 10 is a structural schematic diagram of a further shift register unit according to an embodiment of this application;
FIG. 11 is a structural schematic diagram of a further shift register unit according to an embodiment of this application;
FIG. 12 is a circuit structural schematic diagram of a shift register unit according to an embodiment of this application;
FIG. 13 is a circuit structural schematic diagram of another shift register unit according to an embodiment of this application;
FIG. 14 is a circuit structural schematic diagram of yet another shift register unit according to an embodiment of this application;
FIG. 15 is a circuit structural schematic diagram of still another shift register unit according to an embodiment of this application;
FIG. 16 is a circuit structural schematic diagram of a further shift register unit according to an embodiment of this application;
FIG. 17 is a circuit structural schematic diagram of a further shift register unit according to an embodiment of this application;
FIG. 18 is a circuit structural schematic diagram of a further shift register unit according to an embodiment of this application;
FIG. 19 is a circuit structural schematic diagram of a further shift register unit according to an embodiment of this application;
FIG. 20 is a flowchart schematic diagram of a driving method of a shift register unit according to an embodiment of this application;
FIG. 21 is a flowchart schematic diagram of another driving method of a shift register unit according to an embodiment of this application;
FIG. 22 is a driving timing simulation schematic diagram of the shift register unit shown in FIG. 12 or FIG. 13 according to an embodiment of this application;
FIG. 23 is a driving timing simulation schematic diagram of the shift register unit shown in FIG. 14 according to an embodiment of this application;
FIG. 24 is a driving timing simulation schematic diagram of the shift register unit shown in FIG. 15 according to an embodiment of this application;
FIG. 25 is a driving timing simulation schematic diagram of the shift register unit shown in FIG. 16 according to an embodiment of this application;
FIG. 26 is a driving timing simulation schematic diagram of the shift register unit shown in FIG. 17 according to an embodiment of this application;
FIG. 27 is a driving timing simulation schematic diagram of the shift register unit shown in FIG. 18 according to an embodiment of this application;
FIG. 28 is a driving timing simulation schematic diagram of the shift register unit shown in FIG. 19 according to an embodiment of this application;
FIG. 29 is a structural schematic diagram of a display driving circuit according to an embodiment of this application;
FIG. 30 is a structural schematic diagram of another display driving circuit according to an embodiment of this application; and
FIG. 31 is a structural schematic diagram of a display device according to an embodiment of this application.

### DETAILED DESCRIPTION

To make the objectives, technical solutions, and advantages of this application clearer, the following describes the embodiments of this application in further detail with reference to the accompanying drawings.

It should be noted that transistors adopted in all embodiments of this application may be thin-film transistors or field-effect transistors or other devices with the same characteristics. Field-effect transistors may be, for example, metal-oxide-semiconductor (MOS) field-effect transistors, also referred to as MOS transistors. Moreover, the transistors used in the embodiments of this application are mainly switching transistors according to their roles in circuits. Since the source and drain of the switching transistors used here are symmetrical, the source and drain are interchangeable. In the embodiments of this application, the source is referred to as a first electrode, and the drain is referred to as a second electrode. According to the form in the accompanying drawings, the middle terminal of the transistor is defined as a control electrode, which may also be called a gate; the signal input terminal is the source, and the signal output terminal is the drain. Additionally, the switching transistors used in the embodiments of this application may include any one of P-type switching transistors and N-type switching transistors, wherein a P-type switching transistor is switched on when the gate is at a low potential and switched off when the gate is at a high potential, and an N-type switching transistor is switched on when the gate is at a high potential and switched off when the gate is at a low potential. Furthermore, multiple signals in the various embodiments of this application correspond to a first potential and a second potential. The first potential and the second potential only represent that the potential of the signal has two state quantities and do not represent that the first potential or the second potential has a specific numerical value throughout the text.

The embodiments of this application provide a shift register unit. The driving principle of this shift register unit is simple and facilitates the narrow bezel design of a display device.

For example, the shift register unit may be a CMOS-structured shift register unit. Through the combination of NMOS and PMOS, it can achieve cascade driving. The circuit structure is simple, the driving principle is straightforward, and it facilitates the narrow bezel design of the display device. Herein, NMOS refers to an N-type MOS transistor, PMOS refers to a P-type MOS transistor, and CMOS structure refers to a structure including NMOS and PMOS.

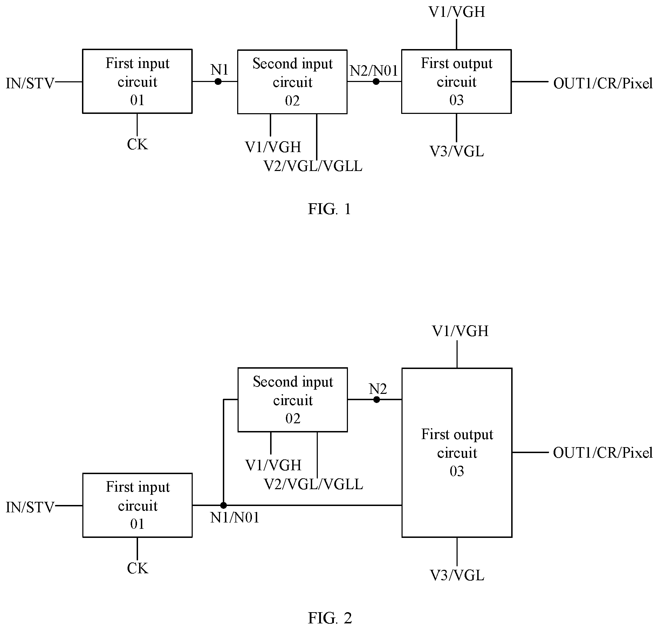

As shown in FIG. 1, the shift register unit includes: a first input circuit 01, a second input circuit 02, and a first output circuit 03.

The first input circuit 01 is connected to a first clock terminal CK, an input terminal IN, and a first node N1, respectively, and is configured to control switching on and off of a connection between the input terminal IN and the first node N1 in response to a first clock signal provided by the first clock terminal CK.

For example, the first input circuit 01 can control the connection between the input terminal IN and the first node N1 to be switched on when the potential of the first clock signal provided by the first clock terminal CK is at a first potential, so that an input signal provided by the input terminal IN can be transmitted to the first node N1; and can control the connection between the input terminal IN and the first node N1 to be switched off when the potential of the first clock signal is at a second potential.

Optionally, in the embodiments of this application, the first potential may be a valid potential, and the second potential may be an invalid potential. The first potential relative to the second potential may be a low potential, that is, the valid first potential may be a low potential, and the invalid second potential may be a high potential. Of course, in some other embodiments, the first potential relative to the second potential may also be a high potential, that is, the valid first potential may be a high potential, and the invalid second potential may be a low potential. It can be understood that for a P-type transistor, the first potential relative to the second potential is a low potential; for an N-type transistor, the first potential relative to the second potential is a high potential. Correspondingly, based on the above example, the first input circuit 01 may include at least a P-type transistor.

The second input circuit 02 is connected to the first node N1, a first power supply terminal V1, a second power supply terminal V2, and a second node N2, respectively, and is configured to control switching on and off of a connection between the first power supply terminal V1 and the second node N2 and control switching on and off of a connection between the second power supply terminal V2 and the second node N2 in response to a potential of the first node N1. Moreover, the first power supply terminal V1 and the second power supply terminal V2 are switched on to the second node N2 in different time periods, respectively.

For example, the second input circuit 02 can control the connection between the first power supply terminal V1 and the second node N2 to be switched on and control the connection between the second power supply terminal V2 and the second node N2 to be switched off when the potential of the first node N1 is at the first potential, so that a first power supply signal provided by the first power supply terminal V1 can be transmitted to the second node N2; and can control the connection between the first power supply terminal V1 and the second node N2 to be switched off and control the connection between the second power supply terminal V2 and the second node N2 to be switched on when the potential of the first node N1 is at the second potential, so that a second power supply signal provided by the second power supply terminal V2 can be transmitted to the second node N2.

That is, as recorded above, the second input circuit 02 can control the first power supply terminal V1 and the second power supply terminal V2 to be switched on to the second node N2 in different time periods under the control of the potential of the first node N1. Based on this, the second input circuit 02 may include at least one P-type transistor and one N-type transistor. Among them, one transistor may be connected to the first power supply terminal V1, and the other transistor may be connected to the second power supply terminal V2. For example, when the first potential is a low potential and the second potential is a high potential, the transistor connected to the first power supply terminal V1 may be a P-type transistor, and the transistor connected to the second power supply terminal V2 may be an N-type transistor.

Optionally, the potential of the first power supply signal provided by the first power supply terminal V1 may be a high potential, and the potential of the second power supply signal provided by the second power supply terminal V2 may be a low potential. Correspondingly, in the embodiments of this application, the first power supply terminal V1 may also be referred to as a pull-up power supply terminal VGH, and the second power supply terminal V2 may be referred to as a pull-down power supply terminal VGL. Thus, when the first potential is a low potential and the second potential is a high potential, when the potential of the first node N1 is at the first potential (i.e., low potential), the potential of the second node N2 may be at the second potential (i.e., high potential); conversely, when the potential of the first node N1 is at the second potential (i.e., high potential), the potential of the second node N2 may be at the first potential (i.e., low potential). That is, the second input circuit 02 can control the potential of the second node N2 to be opposite to the potential of the first node N1 within the same time period. Additionally, since the potential of the first node N1 is the potential of the input signal provided by the input terminal IN transmitted through the first input circuit 01, the second input circuit 02 essentially controls the potential of the second node N2 to be opposite to the potential of the input signal within the same time period.

The first output circuit 03 is connected to the second node N2, a first target node N01, the first power supply terminal V1, a third power supply terminal V3, and a first output terminal OUT1, respectively, and is configured to control switching on and off of a connection between the first power supply terminal V1 and the first output terminal OUT1 in response to a potential of the second node N2, and control switching on and off of a connection between the third power supply terminal V3 and the first output terminal OUT1 in response to a potential of the first target node N01. Moreover, the first power supply terminal V1 and the third power supply terminal V3 are switched on to the first output terminal OUT1 in different time periods, respectively. Herein, the first target node N01 is shared as the first node N1 or the second node N2.

For example, referring to FIG. 1, the first target node N01 is shared as the second node N2, meaning that the second node N2 also serves as the first target node N01, so that the first output circuit 03 controls switching on and off of the connection between the third power supply terminal V3 and the first output terminal OUT1 in response to the potential of the second node N2. Or, referring to FIG. 2, the first target node N01 is shared as the first node N1, meaning that the first node N1 also serves as the first target node N01, so that the first output circuit 03 controls switching on and off of the connection between the third power supply terminal V3 and the first output terminal OUT1 in response to the potential of the first node N1.

For example, with reference to FIG. 1, where the first target node N01 is shared as the second node N2, the first output circuit 03 can control the connection between the first power supply terminal V1 and the first output terminal OUT1 to be switched on and control the connection between the third power supply terminal V3 and the first output terminal OUT1 to be switched off when the potential of the second node N2 is at the first potential, so that the first power supply signal provided by the first power supply terminal V1 can be transmitted to the first output terminal OUT1; and can control the connection between the first power supply terminal V1 and the first output terminal OUT1 to be switched off and control the connection between the third power supply terminal V3 and the first output terminal OUT1 to be switched on when the potential of the second node N2 is at the second potential, so that a third power supply signal provided by the third power supply terminal V3 can be transmitted to the first output terminal OUT1.

That is, when the first target node N01 is shared as the second node N2, the first output circuit 03 can control the first power supply terminal V1 and the third power supply terminal V3 to be switched on to the first output terminal OUT1 in different time periods under the control of the potential of the second node N2, so as to output the first power supply signal or the third power supply signal via the first output terminal OUT1 within one time period. Based on this, the first output circuit 03 may include at least one P-type transistor and one N-type transistor. Among them, one transistor may be connected to the first power supply terminal V1, and the other transistor may be connected to the third power supply terminal V3. For example, when the first potential is a low potential and the second potential is a high potential, the transistor connected to the first power supply terminal V1 may be a P-type transistor, and the transistor connected to the third power supply terminal V3 may be an N-type transistor. Optionally, the potential of the third power supply signal provided by the third power supply terminal V3 may be a low potential. For example, in some embodiments, the third power supply terminal V3 may also be referred to as a pull-down power supply terminal VGL.

For another example, with reference to FIG. 2, where the first target node N01 is shared as the first node N1, since the second input circuit 02 can control the potential of the first node N1 to be opposite to the potential of the second node N2 within the same time period, the first output circuit 03 can control the connection between the first power supply terminal V1 and the first output terminal OUT1 to be switched on and control the connection between the third power supply terminal V3 and the first output terminal OUT1 to be switched off when the potential of the second node N2 is at the first potential (i.e., the potential of the first node N1 is at the second potential), so that the first power supply signal provided by the first power supply terminal V1 can be transmitted to the first output terminal OUT1; and can control the connection between the first power supply terminal V1 and the first output terminal OUT1 to be switched off and control the connection between the third power supply terminal V3 and the first output terminal OUT1 to be switched on when the potential of the second node N2 is at the second potential (i.e., the potential of the first node N1 is at the first potential), so that the third power supply signal provided by the third power supply terminal V3 can be transmitted to the first output terminal OUT1.

That is, when the first target node N01 is shared as the first node N1, the first output circuit 03 can also control the first power supply terminal V1 and the third power supply terminal V3 to be switched on to the first output terminal OUT1 in different time periods under the control of the potentials of the second node N2 and the first node N1, so as to output the first power supply signal or the third power supply signal via the first output terminal OUT1 within one time period. Based on this, the first output circuit 03 may include at least two P-type transistors of the same type or two N-type transistors of the same type. For example, when the first potential is a low potential and the second potential is a high potential, the first output circuit 03 may include two P-type transistors.

Therefore, it can be understood from the previous embodiments that the shift register unit provided by the embodiments of this application may be a CMOS structure including PMOS and NMOS transistors. It has a simple structure and straightforward driving principle, thereby facilitating the narrow bezel design of display devices.

In summary, the embodiments of this application provide a shift register unit. The shift register unit includes two input circuits and one output circuit. One input circuit can control the transmission of an input signal from an input terminal to a first node in response to a clock signal. The other input circuit can control a first power supply terminal and a second power supply terminal to transmit power signals to a second node in different time periods, respectively, in response to a potential of the first node. The output circuit can control a first power supply terminal and a third power supply terminal to transmit power signals to a first output terminal in different time periods, respectively, in response to a potential of the second node or potentials of both the first and second nodes. Thus, it can be seen that the shift register unit includes both P-type and N-type transistors, features a simple structure and driving principle, and facilitates the narrow bezel design of display devices.

Optionally, in one embodiment, referring to FIGS. 1 and 2, the second power supply terminal V2 and the third power supply terminal V3 may be shared. For example, both the second power supply terminal V2 and the third power supply terminal V3 may be the same pull-down power supply terminal VGL. This simplifies wiring, reduces costs, and further facilitates the narrow bezel design of display devices.

Alternatively, in another embodiment, still referring to FIGS. 1 and 2, the second power supply terminal V2 and the third power supply terminal V3 may be independent of each other, and the potential of the second power supply signal provided by the second power supply terminal V2 may be less than that of the third power supply signal provided by the third power supply terminal V3. Here, the comparison may be based on the absolute magnitude of the potentials. For example, the third power supply terminal V3 may be the pull-down power supply terminal VGL described earlier, while the second power supply terminal V2 may be a pull-down power supply terminal VGLL capable of providing a lower-potential signal. Thus, when the transistor connected to the second power supply terminal V2 is an N-type transistor, the bias voltage of this N-type transistor can be reduced, improving the reliability of the shift register unit.

For example, the potential of the power supply signal provided by the pull-down power supply terminal VGLL (i.e., the second power supply terminal V2) may differ by approximately 0.5 volts (V) from that provided by the pull-down power supply terminal VGL (i.e., the third power supply terminal V3).

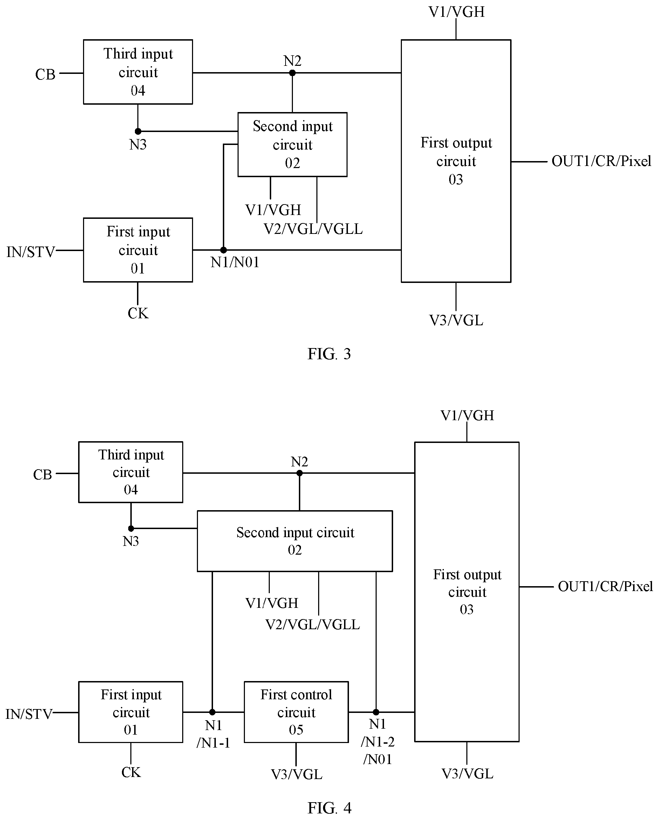

Optionally, in some embodiments, referring to FIG. 3 illustrating another structure of the shift register unit, the second input circuit 02 may also be connected to a third node N3 and configured to control switching on and off of a connection between the first power supply terminal V1 and the third node N3 in response to the potential of the first node N1.

For example, the second input circuit 02 may control the connection between the first power supply terminal V1 and the third node N3 to be switched on when the potential of the first node N1 is at the first potential, enabling the first power supply signal from V1 to be transmitted to N3. It may also control this connection to be switched off when N1 is at the second potential. Combined with the earlier operational principle where the second input circuit 02 controls the connection between V1 and N2 to be switched on when N1 is at the first potential and switched off when N1 is at the second potential, the transistors connecting V1 to N3 and V1 to N2 in the second input circuit 02 may be of the same type. For instance, when the first potential is low and the second potential is high, these transistors may both be P-type transistors.

Furthermore, referring to FIG. 3, the shift register unit may also include: a third input circuit 04.

This third input circuit 04 may be connected to the third node N3, a second clock terminal CB, and the second node N2, respectively. It may control switching on and off of a connection between the second clock terminal CB and the second node N2 in response to the potential of N3 and adjust the potential of N3 based on the second clock signal provided by CB.

For example, the third input circuit 04 may control the connection between CB and N2 to be switched on when the potential of N3 is at the first potential, enabling the second clock signal to be transmitted to N2. It may also control this connection to be switched off when N3 is at the second potential. Optionally, when the first potential is low and the second potential is high, the third input circuit 04 may include at least a P-type transistor.

Additionally, the third input circuit 04 can adjust the potential of N3 based on the second clock signal through coupling effects. For instance, it may pull up the potential of N3 via coupling when the potential of the second clock signal jumps from low to high. This ensures better stability of N3's potential, thereby improving the stability of N2's potential.

It can be understood that by adding the third input circuit 04, the shift register unit gains greater operational flexibility, as the second node N2's potential can be controlled by adjusting the second clock signal from CB.

Optionally, in some embodiments, referring to FIG. 4 illustrating yet another structure, the first node N1 may include: a first sub-node N1-1 and a second sub-node N1-2. The shift register unit may further include: a first control circuit 05.

The first control circuit 05 may be connected to the third power supply terminal V3, N1-1, and N1-2, respectively. It may control switching on and off of a connection between N1-1 and N1-2 in response to the third power supply signal from V3.

For example, if the third power supply signal is a low potential, the first control circuit 05 may maintain the connection between N1-1 and N1-2 continuously switched on under this signal, ensuring their potentials remain consistent. The first control circuit 05 may include at least a P-type transistor.

Further referring to FIG. 4, the first input circuit 01 may be connected to N1-1 and control switching on and off of the connection between IN and N1-1 in response to the first clock signal.

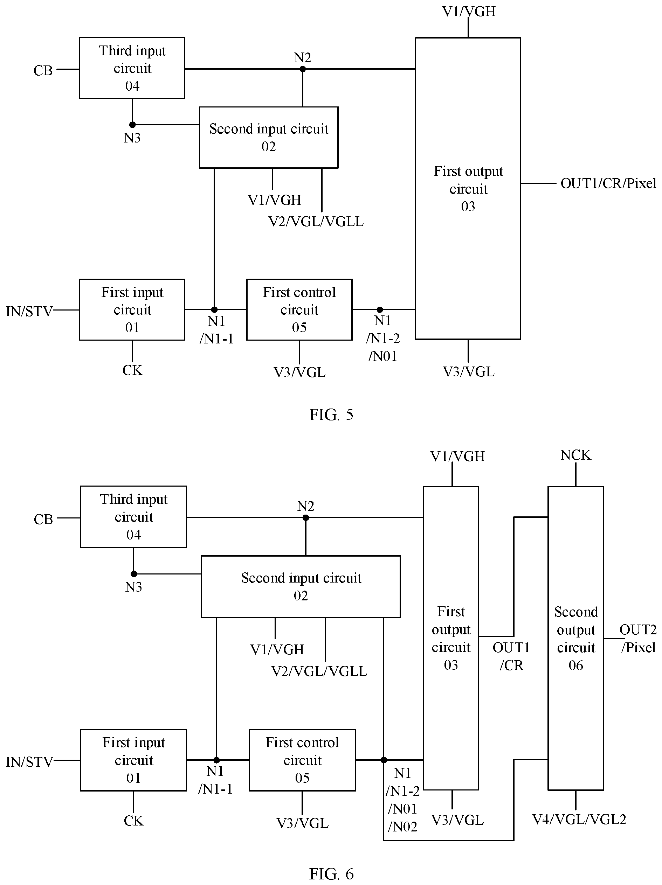

In one embodiment (FIG. 4), the second input circuit 02 may be connected to both N1-1 and N1-2. It may control switching on and off of the connections between V1 and N2 and between V1 and N3 in response to the potential of N1-1. It may also control switching on and off of the connection between V2 and N2 in response to the potential of N1-2. Alternatively, in another embodiment (FIG. 5), where the first target node N01 is shared as the first node N1 (i.e., N01 is N1), the second input circuit 02 may be connected to N1-1 and control switching on and off of the connections between V1 and N2, between V2 and N2, and between V1 and N3 in response to the potential of N1-1. The first output circuit 03 may be connected to N1-2 and control switching on and off of the connection between V3 and OUT1 in response to the potential of N1-2.

Of course, for the embodiment in FIG. 4, the first target node N01 could also be shared as the first node N1 or the second node N2. When shared as N1 (as shown in FIG. 4), the first output circuit 03 may still be connected to the second sub-node N1-2 within N1 and control switching on and off of the connection between V3 and OUT1 in response to the potential of N1-2. That is, the first output circuit 03 may be simultaneously connected to the second input circuit 02, the third input circuit 03, and the first control circuit 05.

It can be understood that the first control circuit 05 isolates N1-1 and N1-2, preventing potential fluctuations at one sub-node from directly affecting the other. For example, when a significant potential drop occurs at N1-2, the first control circuit 05 may act as a resistor to divide the voltage between N1-1 and N1-2, stabilizing the potential of N1-1. This mitigates bias stress on the transistors in the second input circuit 02 connected to N1-1, protecting them from the impact of N1-2's potential changes. Furthermore, with N1-1 stabilized, the potential of N1-2 can be readjusted to restore its stability. This ensures the first output circuit 03 reliably transmits power signals to OUT1, avoiding signal tailing at the output and guaranteeing good output stability.

Optionally, in one embodiment (FIGS. 1-5), the first output terminal OUT1 may be connected to the input terminals IN of other cascaded shift register units and to pixels. That is, OUT1 may serve both as a shift output terminal CR driving the cascaded units and as a drive output terminal driving the pixels (Pixel) to emit light.

Alternatively, in another embodiment, referring to FIG. 6, the first output terminal OUT1 may be connected only to the input terminals IN of other cascaded shift register units. That is, OUT1 serves solely as the shift output terminal CR. In this case, to drive pixels (Pixel), the shift register unit may further include: a second output circuit 06.

This second output circuit 06 may be connected to OUT1, a second target node N02, a third clock terminal NCK, a fourth power supply terminal V4, and a second output terminal OUT2. It may control switching on and off of the connection between NCK and OUT2 in response to the signal output from OUT1 and control switching on and off of the connection between V4 and OUT2 in response to the potential of N02. Moreover, NCK and V4 may be switched on to OUT2 in different time periods, respectively.

Herein, the second output terminal OUT2 may be connected to the pixels (Pixel). That is, with OUT1 acting as the shift output terminal CR (as in FIG. 6), OUT2 serves as the drive output terminal to drive the pixels to emit light. Compared to designs where OUT1 serves both functions, the signals output via OUT1 and OUT2 can operate independently. This ensures reliable pixel driving while guaranteeing stable operation of all cascaded shift register units.

Herein, the second target node N02 may be shared as the first node N1 connected to the first output circuit 03 or the second node N2 connected to the first output circuit 03.

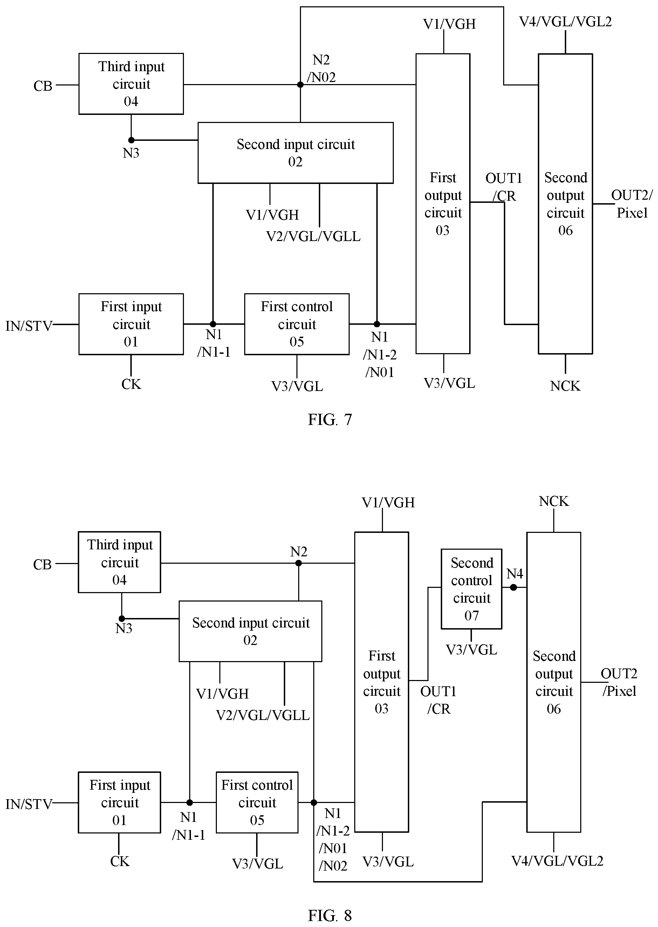

For example, referring to FIG. 7, the second target node N02 is shared as the second node N2, meaning that the second node N2 also serves as the second target node N02, so that the second output circuit 06 controls switching on and off of a connection between the fourth power supply terminal V4 and the second output terminal OUT2 in response to a potential of the second node N2. Based on this, since the first output circuit 03 controls the first power supply terminal V1 to output a first power supply signal at a high potential to the first output terminal OUT1 when the potential of the second node N2 is at the first potential (i.e., low potential), the potential of the second target node N02 and the potential of the signal output via the first output terminal OUT1 may be exactly opposite within the same time period.

Or, referring to FIG. 6, the second target node N02 is shared as the first node N1, meaning that the first node N1 also serves as the second target node N02, so that the second output circuit 06 controls switching on and off of the connection between the fourth power supply terminal V4 and the second output terminal OUT2 in response to the potential of the first node N1. Based on this, when the first target node N01 is shared as the first node N1, since the first output circuit 03 controls the third power supply terminal V2 to output a first power supply signal at a low potential to the first output terminal OUT1 when the potential of the first node N1 is at the first potential (i.e., low potential), the potential of the second target node N02 and the potential of the signal output via the first output terminal OUT1 may be exactly the same within the same time period. And, it can be understood that when the first node N1 includes a first sub-node N1-1 and a second sub-node N1-2, the second target node N02 herein may be shared as the second sub-node N1-2. Of course, in some other embodiments, the second target node N02 may also be shared as the first sub-node N1-1.

For example, the second output circuit 06 can control the connection between the third clock terminal NCK and the second output terminal OUT2 to be switched on and control the connection between the fourth power supply terminal V4 and the second output terminal OUT2 to be switched off when the potential of the signal output via the first output terminal OUT1 is at the first potential, that is, when the potential of the second target node N02 is at the first potential or the second potential, so that the third clock terminal NCK outputs a third clock signal to the second output terminal OUT2; and can control the connection between the third clock terminal NCK and the second output terminal OUT2 to be switched off and control the connection between the fourth power supply terminal V4 and the second output terminal OUT2 to be switched on when the potential of the signal output via the first output terminal OUT1 is at the second potential, that is, when the potential of the second target node N02 is at the first potential or the second potential, so that the fourth power supply terminal V4 outputs a fourth power supply signal to the second output terminal OUT2.

That is, the second output circuit 06 can control the third clock terminal NCK and the fourth power supply terminal V4 to be switched on to the second output terminal OUT2 in different time periods under the control of the signal output via the first output terminal OUT1 and the potential of the second target node N02, so as to output the third clock signal or the fourth power supply signal via the second output terminal OUT2 within one time period. Based on this, the second output circuit 06 may include at least one P-type transistor and one N-type transistor. Among them, one transistor may be connected to the third clock terminal NCK, and the other transistor may be connected to the fourth power supply terminal V4. For example, when the first potential is a low potential and the second potential is a high potential, the transistor connected to the third clock terminal NCK may be a P-type transistor, and the transistor connected to the fourth power supply terminal V4 may be an N-type transistor.

Optionally, the third clock signal provided by the third clock terminal NCK and the second clock signal provided by the second clock terminal CB may be exactly opposite within the same time period.

Optionally, the potential of the fourth power supply signal provided by the fourth power supply terminal V4 may be a low potential. For example, in some embodiments, the fourth power supply terminal V4 may also be referred to as a pull-down power supply terminal VGL.

Optionally, in one embodiment, referring to FIGS. 6 and 7, the fourth power supply terminal V4 may be shared as the third power supply terminal V3. For example, both the fourth power supply terminal V4 and the third power supply terminal V3 may be the same pull-down power supply terminal VGL. This simplifies wiring, reduces costs, and further facilitates the narrow bezel design of the display device.

Or, in another embodiment, referring to FIGS. 6 and 7, the fourth power supply terminal V4 and the third power supply terminal V3 may be independent of each other, and the potential of the fourth power supply signal provided by the fourth power supply terminal V4 may be less than the potential of the third power supply signal provided by the third power supply terminal V3 in terms of absolute value. For example, the third power supply terminal V3 may be the pull-down power supply terminal VGL described earlier, and the fourth power supply terminal V4 may be a pull-down power supply terminal VGL2 capable of providing a lower-potential signal. Thus, when the transistor connected to the fourth power supply terminal V4 is an N-type transistor, the bias voltage of this N-type transistor can be reduced, thereby improving the reliability of the shift register unit.

For example, the potential of the power supply signal provided by the pull-down power supply terminal VGL2 (i.e., the fourth power supply terminal V4) may differ by approximately 0.5 V from that provided by the pull-down power supply terminal VGL (i.e., the third power supply terminal V3).

Optionally, in embodiments where the second power supply terminal V2 and the third power supply terminal V3 are independent of each other, and the fourth power supply terminal V4 and the third power supply terminal V3 are independent of each other, the fourth power supply terminal V4 may be shared as the second power supply terminal V2, such as both being a pull-down power supply terminal VGLL. This can also simplify wiring, reduce costs, and facilitate the narrow bezel design of the display device.

Optionally, when the first node N1 includes the first sub-node N1-1 and the second sub-node N1-2, for embodiments where the fourth power supply terminal V4 is shared as the third power supply terminal V3, the second target node N02 may be set to be shared as the second sub-node N1-2. Thus, compared to setting the second target node N02 to be shared as the first sub-node N1-1, leakage in the transistor connected to the fourth power supply terminal V4 in the second output circuit 06 can be avoided, ensuring that the second output circuit 06 reliably outputs the fourth power supply signal to the second output terminal OUT2. For embodiments where the potential of the fourth power supply signal provided by the fourth power supply terminal V4 is less than that of the third power supply signal provided by the third power supply terminal V3, the second target node N02 may be set to be shared as the second sub-node N1-2 or the first sub-node N1-1.

Optionally, as the first output terminal OUT1 or the second output terminal OUT2 connected to the pixel Pixel, it may be connected to a transistor in the pixel circuit of the pixel Pixel via a gate line Gate, to output a gate driving signal to the connected transistor via the gate line Gate. Herein, the transistor in the pixel circuit may be, for example, an N-type data writing transistor. Correspondingly, the shift register unit may also be referred to as a CMOS-structured Gate GOA driving circuit. Of course, it may also be connected to a transistor in the pixel circuit of the pixel Pixel via other signal lines, to output signals to the connected transistor via other signal lines. For example, the other signal line may be a light emission control line EM. Correspondingly, the transistor in the pixel circuit may be, for example, an N-type light emission control transistor, and the signal output via the light emission control line EM may be a light emission control signal. Correspondingly, the shift register unit may also be referred to as a CMOS-structured EM GOA driving circuit.

And, it can be understood that, combined with FIGS. 1 to 7, for the first-stage shift register unit among the cascade-connected multi-stage shift register units, its input terminal IN may be connected to a start signal terminal STV to receive a start signal provided by the start signal terminal STV and operate under the control of the start signal.

Optionally, in some embodiments, the high potential and low potential of the start signal provided by the start signal terminal STV, the high potential and low potential of the first clock signal provided by the first clock terminal CK, and the high potential and low potential of the second clock signal provided by the second clock terminal CB may be equal to the potential of the power supply signal provided by a pull-up power supply terminal VGH and the potential of the power supply signal provided by a pull-down power supply terminal VGL, respectively. The high potential and low potential of the third clock signal provided by the third clock terminal NCK may be equal to the potential of the power supply signal provided by the pull-up power supply terminal VGH and the potential of the power supply signal provided by a pull-down power supply terminal VGL2, respectively.

Optionally, in some embodiments, referring to FIG. 8 illustrating another structure of the shift register unit, the shift register unit may further include: a second control circuit 07.

The second control circuit 07 may be connected between the first output terminal OUT1 and the second output circuit 06, and may also be connected to the third power supply terminal V3. It is configured to control switching on and off of a connection between the first output terminal OUT1 and the second output circuit 06 in response to a third power supply signal provided by the third power supply terminal V3. The connection node between the second control circuit 07 and the second output circuit 06 is labeled as a fourth node N4 in the figure.

For example, the second control circuit 07 may control the connection between the first output terminal OUT1 and the second output circuit 06 to be continuously switched on under the control of a low-potential third power supply signal, that is, control the connection between the first output terminal OUT1 and the fourth node N4 to be continuously switched on. Thus, the potential of the fourth node N4 and the potential of the signal output via the first output terminal OUT1 may be consistent. And, the second control circuit 07 may include at least a P-type transistor.

It can be understood that, similar to the first control circuit 05, by providing the second control circuit 07, it can isolate the first output terminal OUT1 from the fourth node N4, preventing potential fluctuations at one terminal from directly affecting the other terminal. For example, in some embodiments, when the potential of the fourth node N4 drops significantly, the second control circuit 07 may act as a resistor to divide the voltage between the first output terminal OUT1 and the fourth node N4, ensuring that the potential of the signal output via the first output terminal OUT1 remains relatively stable, thereby ensuring good output stability.

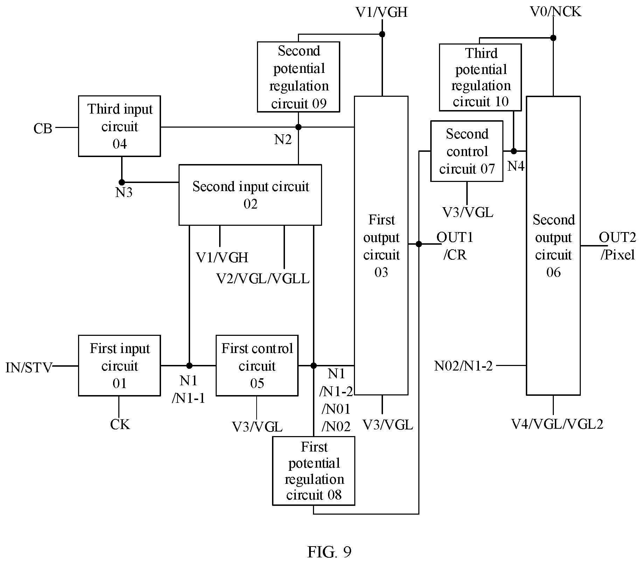

Optionally, in some embodiments, referring to FIGS. 9 to 11 illustrating other structures of the shift register unit, the shift register unit may further include at least one of the following circuits: a first potential regulation circuit 08, a second potential regulation circuit 09, and a third potential regulation circuit 10.

Herein, the first potential regulation circuit 08 may be connected to the first target node N01 and the first output terminal OUT1, respectively, and configured to regulate a potential of the first target node N01 based on a signal output via the first output terminal OUT1. Herein, the first target node N01 may be shared as the first node N1. That is, the first potential regulation circuit 08 may be connected to the first node N1 and the first output terminal OUT1, respectively. And, combined with FIGS. 9 to 11, when the first node N1 includes a first sub-node N1-1 and a second sub-node N1-2, the first target node N01 herein may be shared as the second sub-node N1-2. That is, the first potential regulation circuit 08 may be connected to the second sub-node N1-2 and the first output terminal OUT1, respectively.

The second potential regulation circuit 09 may be connected to the second node N2 and the first power supply terminal V1, respectively, and configured to regulate a potential of the second node N2 based on a first power supply signal provided by the first power supply terminal V1.

The third potential regulation circuit 10 may be connected to a target signal terminal V0 and a connection node (i.e., the fourth node N4) between the second control circuit 07 and the second output circuit 06, respectively, and configured to regulate a potential of the connection node based on a signal provided by the target signal terminal V0.

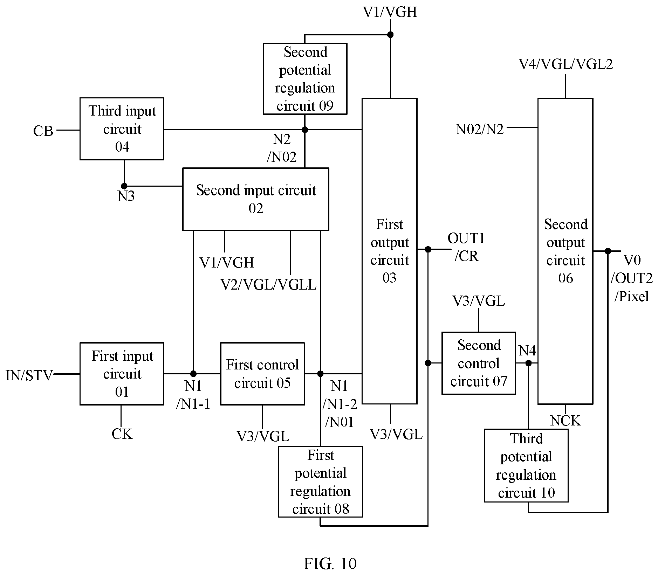

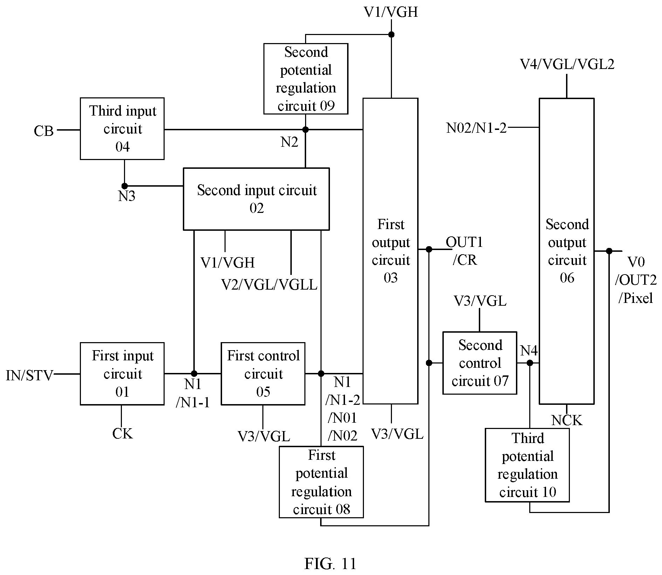

Herein, combined with FIG. 6, in a case where the second target node N02 is shared as the first node N1 (e.g., the second sub-node N1-2), the target signal terminal V0 may be the third clock terminal NCK shown in FIG. 9 or the second output terminal OUT2 shown in FIG. 11. That is, when the second target node N02 is the first node N1, the third potential regulation circuit 10 may regulate the potential of the fourth node N4 based on the third clock signal provided by the third clock terminal NCK or the signal output via the second output terminal OUT2. Combined with FIG. 7, in a case where the second target node N02 is shared as the second node N2, the target signal terminal V0 may be the second output terminal OUT2 shown in FIG. 10. That is, when the second target node N02 is the second node N2, the third potential regulation circuit 10 may regulate the potential of the fourth node N4 based on the signal output via the second output terminal OUT2.

Optionally, whether it is the first potential regulation circuit 08, the second potential regulation circuit 09, or the third potential regulation circuit 10, each may regulate the potential of the connected node through coupling effects. This ensures good stability of the potentials at each node, thereby ensuring reliable operation of the shift register unit.

It can be understood that, combined with FIG. 9, when the second target node N02 is shared as the second sub-node N1-2 in the first node N1 and the target signal terminal V0 is set as the third clock terminal NCK, that is, when the third potential regulation circuit 10 is connected to the third clock terminal NCK and regulates the potential of the fourth node N4 based on the third clock signal provided by the third clock terminal NCK, potential fluctuations of the third clock signal may couple to the first output terminal OUT1 due to coupling effects, causing the potential of the signal output via the first output terminal OUT1 to fluctuate as well.

Whereas, combined with FIG. 10, when the second target node N02 is shared as the second node N2 and the target signal terminal V0 is set as the second output terminal OUT2, that is, when the third potential regulation circuit 10 is connected to the second output terminal OUT2 and regulates the potential of the fourth node N4 based on the signal output via the second output terminal OUT2, the issue of potential fluctuation in the signal output via the first output terminal OUT1 under the FIG. 9 structure can be improved. However, when the potential of the first node N1 is at a high potential and the potential of the second node N2 is at a low potential, the first output circuit 03 controls the first power supply terminal V1 to output a first power supply signal at a high potential to the first output terminal OUT1, causing the potential of the signal output via the first output terminal OUT1 to be at a high potential. This results in both the N-type transistor connected to the fourth power supply terminal V4 and the P-type transistor connected to the third clock terminal NCK in the second output circuit 06 being turned off, placing the second output terminal OUT2 in a floating state. Consequently, the second output circuit 06 cannot reliably control the fourth power supply terminal V4 to output a fourth power supply signal at a low potential to the second output terminal OUT2.

Continuing with FIG. 11, when the second target node N02 is shared as the second sub-node N1-2 in the first node N1 and the target signal terminal V0 is set as the second output terminal OUT2, that is, when the third potential regulation circuit 10 is connected to the second output terminal OUT2 and regulates the potential of the fourth node N4 based on the signal output via the second output terminal OUT2, the potential of the second sub-node N1-2 is at a low potential and the potential of the second node N2 is at a high potential. This causes the first output circuit 03 to control the third power supply terminal V3 to output a third power supply signal at a low potential to the first output terminal OUT1, resulting in the potential of the signal output via the first output terminal OUT1 being at a low potential. Thus, the second output circuit 06 can reliably control the fourth power supply terminal V4 or the third clock terminal NCK to output signals to the second output terminal OUT2. This not only improves the issue of potential fluctuation in the signal output via the first output terminal OUT1 under the FIG. 9 structure but also avoids the floating state of the second output terminal OUT2 under the FIG. 10 structure, achieving better results.

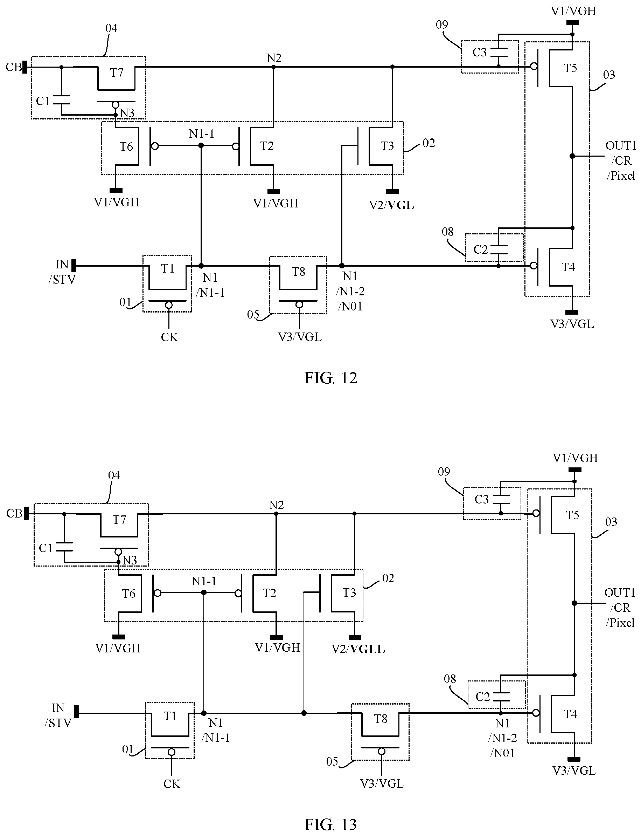

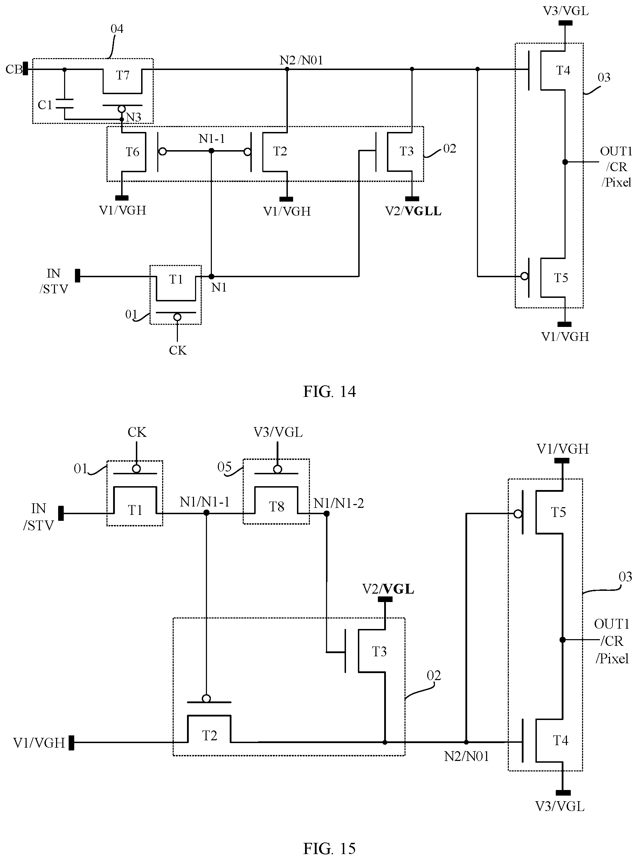

Optionally, taking the structure shown in FIG. 4 as an example, where both the second power supply terminal V2 and the third power supply terminal V3 are the same pull-down power supply terminal VGL, FIG. 12 schematically shows a circuit structural schematic diagram of a shift register unit according to an embodiment of this application. Taking the structure shown in FIG. 5 as an example, where the second power supply terminal V2 and the third power supply terminal V3 are the pull-down power supply terminal VGLL and VGL, respectively, FIG. 13 schematically shows another circuit structural schematic diagram of a shift register unit according to an embodiment of this application. Taking the structure shown in FIG. 3 as an example, where the second power supply terminal V2 and the third power supply terminal V3 are the pull-down power supply terminal VGLL and VGL, respectively, FIG. 14 schematically shows yet another circuit structural schematic diagram of a shift register unit according to an embodiment of this application. And, taking the structure combining FIG. 1 and FIG. 4 as an example, where both the second power supply terminal V2 and the third power supply terminal V3 are the same pull-down power supply terminal VGL, FIG. 15 schematically shows still another circuit structural schematic diagram of a shift register unit according to an embodiment of this application.

Optionally, referring to FIGS. 12 to 15, the first input circuit 01 may include: a first transistor T1. And the first transistor T1 may be a P-type transistor.

A gate of the first transistor T1 may be connected to the first clock terminal CK, a first electrode of the first transistor T1 may be connected to the input terminal IN, and a second electrode of the first transistor T1 may be connected to the first node N1. Of course, the input terminal IN of the first-stage shift register unit may be connected to a start signal terminal STV.

It can be understood that when the first node N1 includes a first sub-node N1-1 and a second sub-node N1-2, referring to FIG. 12, the second electrode of the first transistor T1 may be connected to the first sub-node N1-1.

Optionally, continuing to refer to FIGS. 12 to 15, the second input circuit 02 may include: a second transistor T2 and a third transistor T3. And the second transistor T2 and the third transistor T3 may be a P-type transistor and an N-type transistor, respectively.

A gate of the second transistor T2 may be connected to the first node N1, a first electrode of the second transistor T2 may be connected to the first power supply terminal V1, and a second electrode of the second transistor T2 may be connected to the second node N2.

A gate of the third transistor T3 may be connected to the first node N1, a first electrode of the third transistor T3 may be connected to the second power supply terminal V2, and a second electrode of the third transistor T3 may be connected to the second node N2.

It can be understood that when the first node N1 includes the first sub-node N1-1 and the second sub-node N1-2, referring to FIG. 12, the gate of the second transistor T2 may be connected to the first sub-node N1-1. Referring to FIGS. 12 and 13, the gate of the third transistor T3 may be connected to the first sub-node N1-1 or the second sub-node N1-2. And, as recorded earlier, by setting the second power supply terminal V2 as the pull-down power supply terminal VGLL capable of providing a lower-potential signal, leakage in the third transistor T3 can be reduced, thereby lowering the bias voltage of the third transistor T3 and improving the reliability of the shift register unit.

Optionally, continuing to refer to FIGS. 12 to 15, the first output circuit 03 may include: a fourth transistor T4 and a fifth transistor T5. And the fourth transistor T4 and the fifth transistor T5 may both be P-type transistors, or may be an N-type transistor and a P-type transistor, respectively.

A gate of the fourth transistor T4 may be connected to the first target node N01, a first electrode of the fourth transistor T4 may be connected to the third power supply terminal V3, and a second electrode of the fourth transistor T4 may be connected to the first output terminal OUT1.

A gate of the fifth transistor T5 may be connected to the second node N2, a first electrode of the fifth transistor T5 may be connected to the first power supply terminal V1, and a second electrode of the fifth transistor T5 may be connected to the first output terminal OUT1.

For example, referring to FIGS. 12 and 13, when the first target node N01 is shared as the second sub-node N1-2 in the first node N1, both the fourth transistor T4 and the fifth transistor T5 may be P-type transistors. Referring to FIGS. 14 and 15, when the first target node N01 is shared as the second node N2, the fourth transistor T4 may be an N-type transistor and the fifth transistor T5 may be a P-type transistor.

It can be understood that the first output circuit 03 shown in FIGS. 14 and 15 can be considered a CMOS buffer structure. Herein, the NMOS may use a high gate voltage to output a low level, and the PMOS may use a low gate voltage to output a high level.

It can also be understood that when the first target node N01 is shared as the second sub-node N1-2, referring to FIGS. 12 and 13, the gate of the fourth transistor T4 may be connected to the second sub-node N1-2. When the first target node N01 is shared as the second node N2, referring to FIGS. 14 and 15, the gate of the fourth transistor T4 may be connected to the second node N2.

Optionally, continuing to refer to FIGS. 12 to 14, when the third input circuit 04 is included, the second input circuit 02 may further include: a sixth transistor T6. And the sixth transistor T6 may be a P-type transistor.

A gate of the sixth transistor T6 may be connected to the first node N1, a first electrode of the sixth transistor T6 may be connected to the first power supply terminal V1, and a second electrode of the sixth transistor T6 may be connected to the third node N3.

It can be understood that when the first node N1 includes the first sub-node N1-1 and the second sub-node N1-2, referring to FIGS. 12 to 14, the gate of the sixth transistor T6 may be connected to the first sub-node N1-1.

Optionally, continuing to refer to FIGS. 12 to 14, the third input circuit 04 may include: a seventh transistor T7 and a first capacitor C1. And the seventh transistor T7 may be a P-type transistor.

A gate of the seventh transistor T7 may be connected to the third node N3, a first electrode of the seventh transistor T7 may be connected to the second clock terminal CB, and a second electrode of the seventh transistor T7 may be connected to the second node N2.

One terminal of the first capacitor C1 may be connected to the third node N3, and the other terminal of the first capacitor C1 may be connected to the second clock terminal CB. That is, the first capacitor C1 may be connected in series between the second clock terminal CB and the third node N3.

Optionally, continuing to refer to FIGS. 12, 13, and 15, when the first control circuit 05 is included, the first control circuit 05 may include: an eighth transistor T8. And the eighth transistor T8 may be a P-type transistor.

A gate of the eighth transistor T8 may be connected to the third power supply terminal V3, a first electrode of the eighth transistor T8 may be connected to the first sub-node N1-1, and a second electrode of the eighth transistor T8 may be connected to the second sub-node N1-2.

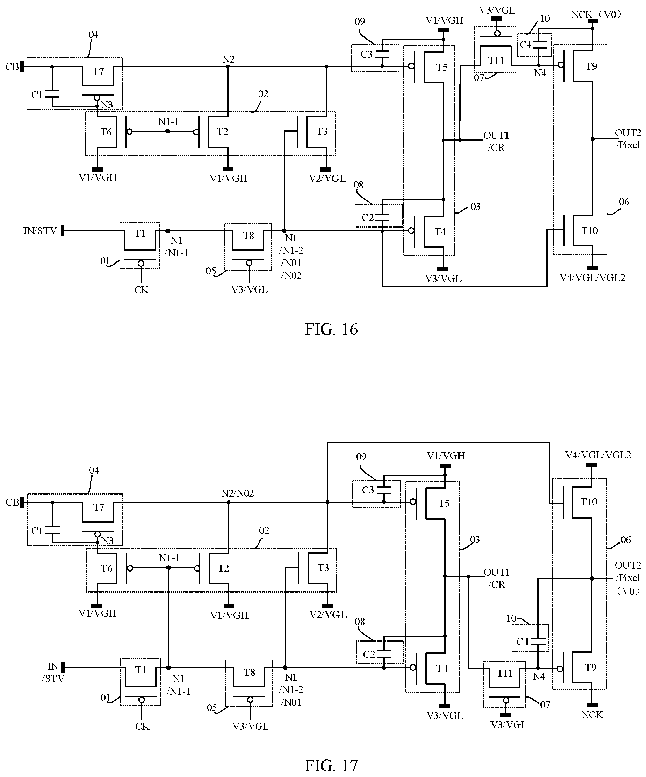

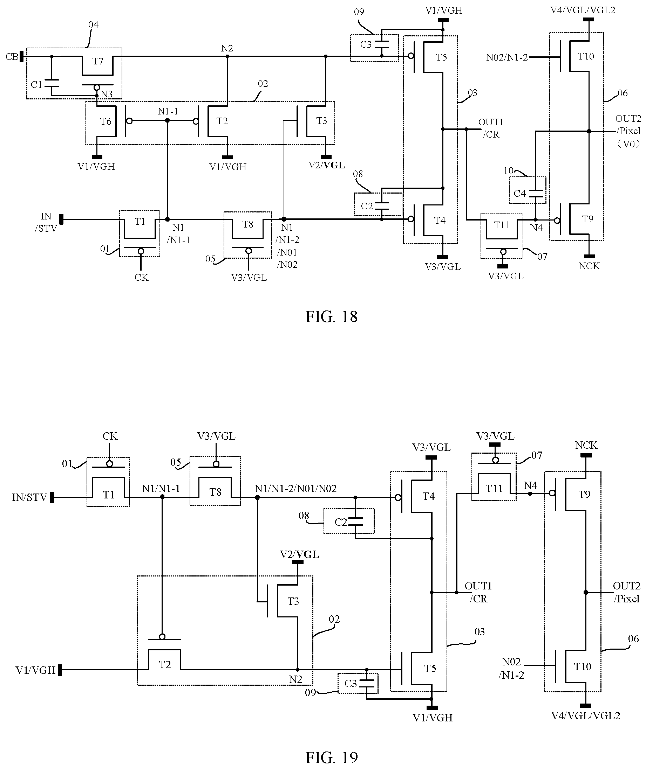

Optionally, based on FIG. 12 and taking the structure shown in FIG. 9 as an example, FIG. 16 schematically shows a circuit structural schematic diagram of a further shift register unit according to an embodiment of this application. Based on FIG. 12 and taking the structure shown in FIG. 10 as an example, FIG. 17 schematically shows a circuit structural schematic diagram of a further shift register unit according to an embodiment of this application. Based on FIG. 12 and taking the structure shown in FIG. 11 as an example, FIG. 18 schematically shows a circuit structural schematic diagram of a further shift register unit according to an embodiment of this application. And, based on FIG. 15 and combined with FIGS. 8 and 12, FIG. 19 schematically shows a circuit structural schematic diagram of a further shift register unit according to an embodiment of this application.

Optionally, referring to FIGS. 16 to 19, the second output circuit 06 may include: a ninth transistor T9 and a tenth transistor T10. And the ninth transistor T9 and the tenth transistor T10 may be a P-type transistor and an N-type transistor, respectively.

A gate of the ninth transistor T9 may be connected to the first output terminal OUT1, a first electrode of the ninth transistor T9 may be connected to the third clock terminal NCK, and a second electrode of the ninth transistor T9 may be connected to the second output terminal OUT2.

A gate of the tenth transistor T10 may be connected to the second target node N02, a first electrode of the tenth transistor T10 may be connected to the fourth power supply terminal V4, and a second electrode of the tenth transistor T10 may be connected to the second output terminal OUT2.

It can be understood that, similar to the first output circuit 03, the second output circuit 06 shown in FIGS. 16 to 19 may be considered a CMOS buffer structure. Herein, the NMOS may output a low level using a high gate voltage, and the PMOS may output a high level using a low gate voltage.

It can also be understood that when the second target node N02 is shared as the second sub-node N1-2, referring to FIGS. 16, 18, and 19, the gate of the tenth transistor T10 may be connected to the second sub-node N1-2. When the second target node N02 is shared as the second node N2, referring to FIG. 17, the gate of the tenth transistor T10 may be connected to the second node N2.

Optionally, continuing to refer to FIGS. 16 to 19, the second control circuit 07 may include: an eleventh transistor T11. And the eleventh transistor T11 may be a P-type transistor.

A gate of the eleventh transistor T11 may be connected to the third power supply terminal V3, a first electrode of the eleventh transistor T11 may be connected to the first output terminal OUT1, and a second electrode of the eleventh transistor T11 may be connected to the second output circuit 06 (i.e., the fourth node N4).

Optionally, continuing to refer to FIGS. 12, 13, and 16 to 19, the first potential regulation circuit 08 may include: a second capacitor C2; the second potential regulation circuit 09 may include: a third capacitor C3; and the third potential regulation circuit 10 may include: a fourth capacitor C4.

One terminal of the second capacitor C2 may be connected to the first target node N01, and the other terminal of the second capacitor C2 may be connected to the first output terminal OUT1. That is, the second capacitor C2 may be connected in series between the first target node N01 and the first output terminal OUT1. Herein, the first target node N01 may be the second sub-node N1-2 included in the first node N1.

One terminal of the third capacitor C3 may be connected to the second node N2, and the other terminal of the third capacitor C3 may be connected to the first power supply terminal V1. That is, the third capacitor C3 may be connected in series between the second node N2 and the first power supply terminal V1.

One terminal of the fourth capacitor C4 may be connected to the connection node (i.e., the fourth node N4), and the other terminal of the fourth capacitor C4 may be connected to the target signal terminal V0. That is, the fourth capacitor C4 may be connected in series between the fourth node N4 and the target signal terminal V0.

It can be understood that when the target signal terminal V0 is the third clock terminal NCK, referring to FIG. 16, the fourth capacitor C4 may be connected in series between the fourth node N4 and the third clock terminal NCK. When the target signal terminal V0 is the second output terminal OUT2, referring to FIGS. 17 and 18, the fourth capacitor C4 may be connected in series between the fourth node N4 and the second output terminal OUT2.

It can be understood that the circuit diagrams shown in FIGS. 12 to 19 are merely illustrative. Any circuit diagram constructed based on the structural diagrams shown in FIGS. 1 to 11 falls within the protection scope of the embodiments of this application.

Based on the above embodiments, on one hand, the embodiments of this application provide a novel CMOS EM GOA driving circuit (e.g., as shown in FIG. 12). Through the combination of NMOS and PMOS, it can achieve cascade driving to control light emission of light-emitting elements in pixels and implement functions such as signal reset. Adopting a CMOS structure simplifies the architecture of the EM GOA driving circuit, facilitating the narrow bezel design of display devices.

On the other hand, the embodiments of this application provide a novel CMOS Gate GOA driving circuit (e.g., as shown in FIG. 16). Similarly, through the combination of NMOS and PMOS, it can achieve cascade driving. By leveraging the characteristic differences between N-type transistors made of oxide materials and P-type transistors made of low-temperature polysilicon (LTPS) materials, it ensures stable output of required gate driving signals to N-type transistors in pixel circuits. Moreover, it reduces the number of transistors, ensuring circuit simplicity and facilitating the narrow bezel design of display devices. Additionally, the dual-output structure (shift output terminal and drive output terminal) enhances output stability. It can be understood that the transistor architecture including LTPS+oxide materials may also be referred to as an LTPO structure.

Furthermore, as display panel sizes increase, resolution and frequency rise, and the time for scanning one row (i.e., 1H) decreases significantly, severely affecting image quality compensation. Traditional shift register units driving oxide-structured pixel circuits often perform data writing and threshold voltage compensation simultaneously. Less 1H time means less compensation time, making reliable compensation unachievable. The CMOS-structured shift register unit provided in the embodiments of this application can circumvent this issue, ensuring reliable threshold voltage compensation in pixel circuits.

In summary, the embodiments of this application provide a shift register unit. The shift register unit includes two input circuits and one output circuit. One input circuit controls transmission of an input signal from an input terminal to a first node in response to a clock signal. The other input circuit controls a first power supply terminal and a second power supply terminal to transmit power supply signals to a second node in different time periods, respectively, in response to a potential of the first node. The output circuit controls a first power supply terminal and a third power supply terminal to transmit power supply signals to a first output terminal in different time periods, respectively, in response to a potential of the second node or potentials of both the first and second nodes. Thus, the shift register unit includes both P-type and N-type transistors, features a simple structure and driving principle, and facilitates the narrow bezel design of display devices.

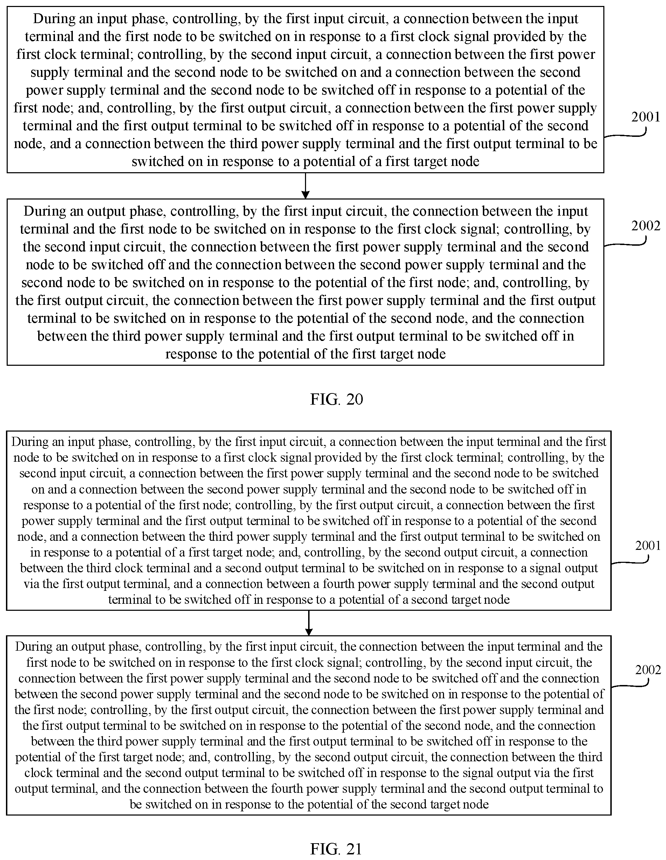

The embodiments of this application also provide a driving method for a shift register unit, configured to drive the shift register unit according to any one of FIGS. 1 to 19. As shown in FIG. 20, the method includes:

In step 2001, during an input phase, controlling, by the first input circuit, a connection between the input terminal and the first node to be switched on in response to a first clock signal provided by the first clock terminal; controlling, by the second input circuit, a connection between the first power supply terminal and the second node to be switched on and a connection between the second power supply terminal and the second node to be switched off in response to a potential of the first node; and, controlling, by the first output circuit, a connection between the first power supply terminal and the first output terminal to be switched off in response to a potential of the second node, and a connection between the third power supply terminal and the first output terminal to be switched on in response to a potential of a first target node.

Wherein, the first target node is shared as the first node or the second node.

In step 2002, during an output phase, controlling, by the first input circuit, the connection between the input terminal and the first node to be switched on in response to the first clock signal; controlling, by the second input circuit, the connection between the first power supply terminal and the second node to be switched off and the connection between the second power supply terminal and the second node to be switched on in response to the potential of the first node; and, controlling, by the first output circuit, the connection between the first power supply terminal and the first output terminal to be switched on in response to the potential of the second node, and the connection between the third power supply terminal and the first output terminal to be switched off in response to the potential of the first target node.

Optionally, in some embodiments, the first output terminal may be configured to be connected to an input terminal of another cascade-connected shift register unit and a pixel, respectively. Or, the first output terminal may be configured to be connected to the input terminal of another cascade-connected shift register unit, and the shift register unit may further include: a second output circuit. Thus, referring to FIG. 21, the method may further include:

In step 2001, during the input phase, controlling, by the second output circuit, a connection between the third clock terminal and a second output terminal to be switched on in response to a signal output via the first output terminal, and a connection between a fourth power supply terminal and the second output terminal to be switched off in response to a potential of a second target node, wherein the second output terminal is configured to be connected to the pixel.

Wherein, the second target node is shared as the first node connected to the first output circuit or the second node connected to the first output circuit.

In step 2002, during the output phase, controlling, by the second output circuit, the connection between the third clock terminal and the second output terminal to be switched off in response to the signal output via the first output terminal, and the connection between the fourth power supply terminal and the second output terminal to be switched on in response to the potential of the second target node.

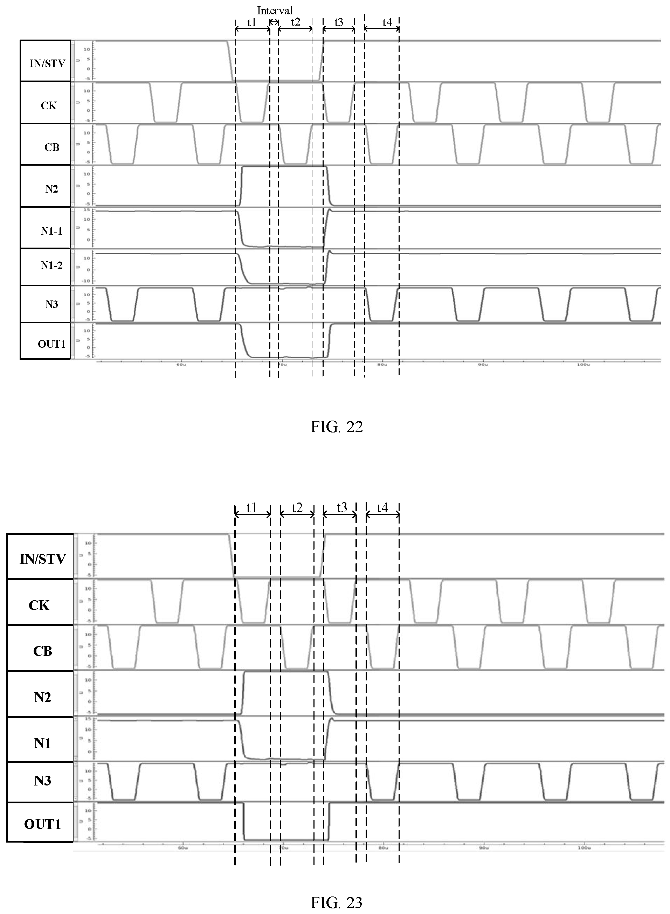

Optionally, taking the circuit structure shown in FIG. 12 as an example, where the first potential is a low potential and the second potential is a high potential, FIG. 22 shows a driving timing simulation diagram of a shift register unit. Referring to FIG. 22, the shift register unit may execute four phases from t1 to t4.

During the t1 phase: the potential of the first clock signal provided by the first clock terminal CK may be a low potential, the potential of the second clock signal provided by the second clock terminal CB may be a high potential, and the potential of the input signal provided by the input terminal IN may be a low potential. Thus, the P-type first transistor T1 may be switched on. Consequently, the low-potential input signal from the input terminal IN may be transmitted to the first sub-node N1-1 via the switched-on first transistor T1, causing the potential of the first sub-node N1-1 to be a low potential. Since the potential of the third power supply signal provided by the third power supply terminal V3 (i.e., the pull-down power supply terminal VGL) remains at a low potential, the P-type eighth transistor T8 may remain switched on. Thus, the low potential of the first sub-node N1-1 may be transmitted to the second sub-node N1-2 via the switched-on eighth transistor T8, causing the potential of the second sub-node N1-2 to also be a low potential. With the potentials of both the first sub-node N1-1 and the second sub-node N1-2 at a low potential, the P-type second transistor T2, P-type sixth transistor T6, and P-type fourth transistor T4 may all be switched on, while the N-type third transistor T3 may be switched off. Consequently, the high-potential first power supply signal provided by the first power supply terminal V1 (i.e., the pull-up power supply terminal VGH) may be transmitted to the second node N2 and the third node N3 via the switched-on second transistor T2 and sixth transistor T6, respectively, and the low-potential third power supply signal provided by the third power supply terminal V3 may be transmitted to the first output terminal OUT1 via the switched-on fourth transistor T4. With the potentials of both the second node N2 and the third node N3 at a high potential, the P-type seventh transistor T7 and P-type fifth transistor T5 may both be switched off.

During the t1 phase: the potential of the first clock signal provided by the first clock terminal CK may be a high potential, the potential of the second clock signal provided by the second clock terminal CB may be a low potential, and the potential of the input signal provided by the input terminal IN may be a low potential. Thus, the P-type first transistor T1 may be switched off. Under the coupling effect of the first capacitor C1, the potential of the third node N3 may remain at a high potential. Under the coupling effect of the second capacitor C2, the potential of the second sub-node N1-2 may remain at a low potential. Correspondingly, with the eighth transistor T8 remaining switched on, the potential of the first sub-node N1-1 may also remain at a low potential. Under the coupling effect of the third capacitor C3, the potential of the second node N2 may remain at a high potential. With the potentials of both the first sub-node N1-1 and the second sub-node N1-2 remaining at a low potential, the P-type second transistor T2, P-type sixth transistor T6, and P-type fourth transistor T4 may all remain switched on, while the N-type third transistor T3 remains switched off. Consequently, the high-potential first power supply signal provided by the first power supply terminal V1 may continue to be transmitted to the second node N2 and the third node N3 via the switched-on second transistor T2 and sixth transistor T6, respectively, and the low-potential third power supply signal provided by the third power supply terminal V3 may be transmitted to the first output terminal OUT1 via the switched-on fourth transistor T4. With the potentials of both the second node N2 and the third node N3 remaining at a high potential, the P-type seventh transistor T7 and P-type fifth transistor T5 may both remain switched off.

During the t3 phase: the potential of the first clock signal provided by the first clock terminal CK may be a low potential, the potential of the second clock signal provided by the second clock terminal CB may be a high potential, and the potential of the input signal provided by the input terminal IN may be a high potential. Thus, the P-type first transistor T1 may be switched on. Consequently, the high-potential input signal from the input terminal IN may be transmitted to the first sub-node N1-1 via the switched-on first transistor T1, causing the potential of the first sub-node N1-1 to be a high potential. Since the eighth transistor T8 remains switched on, the high potential of the first sub-node N1-1 may be transmitted to the second sub-node N1-2 via the switched-on eighth transistor T8, causing the potential of the second sub-node N1-2 to also be a high potential. With the potentials of both the first sub-node N1-1 and the second sub-node N1-2 at a high potential, the P-type second transistor T2, P-type sixth transistor T6, and P-type fourth transistor T4 may all be switched off, while the N-type third transistor T3 may be switched on. Consequently, the low-potential second power supply signal provided by the second power supply terminal V2 (i.e., the pull-down power supply terminal VGL) may be transmitted to the second node N2 via the switched-on third transistor T3. Additionally, under the coupling effect of the first capacitor C1, the potential of the third node N3 may remain at a high potential. With the potential of the second node N2 at a low potential and the potential of the third node N3 at a high potential, the P-type seventh transistor T7 may be switched off, and the P-type fifth transistor T5 may be switched on. Consequently, the high-potential first power supply signal provided by the first power supply terminal V1 may be transmitted to the first output terminal OUT1 via the switched-on fifth transistor T5.

During the t4 phase: the potential of the first clock signal provided by the first clock terminal CK may be a high potential, the potential of the second clock signal provided by the second clock terminal CB may be a low potential, and the potential of the input signal provided by the input terminal IN may be a high potential. Thus, the P-type first transistor T1 may be switched off. Under the coupling effect of the first capacitor C1, the potential of the third node N3 may change to a low potential. Under the coupling effect of the second capacitor C2, the potential of the second sub-node N1-2 may remain at a high potential. Correspondingly, with the eighth transistor T8 remaining switched on, the potential of the first sub-node N1-1 may also remain at a high potential. Under the coupling effect of the third capacitor C3, the potential of the second node N2 may remain at a low potential. With the potentials of both the first sub-node N1-1 and the second sub-node N1-2 remaining at a high potential, the P-type second transistor T2, P-type sixth transistor T6, and P-type fourth transistor T4 may all remain switched off, while the N-type third transistor T3 remains switched on. Consequently, the low-potential second power supply signal provided by the second power supply terminal V2 may continue to be transmitted to the second node N2 via the switched-on third transistor T3. With the potentials of both the second node N2 and the third node N3 at a low potential, the P-type seventh transistor T7 and P-type fifth transistor T5 may both be switched on. Consequently, not only can the low-potential second clock signal provided by the second clock terminal CB be transmitted to the second node N2 via the switched-on seventh transistor T7, pulling down the second node N2 to a lower potential and ensuring the P-type fifth transistor T5 is fully switched on, but the high-potential first power supply signal provided by the first power supply terminal V1 can also continue to be reliably transmitted to the first output terminal OUT1 via the fully switched-on fifth transistor T5.

Optionally, assuming the low potential is VGL1 and the high potential is VGH1, combined with FIG. 22, it can be seen that:

During the t1 phase, the potential of the first sub-node N1-1, the potential of the second sub-node N1-2, and the potential of the signal output via the first output terminal OUT1 may all be the low potential VGL1, while the potential of the second node N2 and the potential of the third node N3 may both be the high potential VGH1. That is, N1-1=VGL1, N1-2=VGL1, N2=VGH1, N3=VGH1, OUT1/CR=VGL1.

During the t2 phase, the potential of the first sub-node N1-1, the potential of the second sub-node N1-2, and the potential of the signal output via the first output terminal OUT1 may all be the low potential VGL1, while the potential of the second node N2 and the potential of the third node N3 may both be the high potential VGH1. That is, N1-1=VGL1, N1-2=VGL1, N2=VGH1, N3=VGH1, OUT1/CR=VGL1.

During the t3 phase, the potential of the first sub-node N1-1, the potential of the second sub-node N1-2, the potential of the third node N3, and the potential of the signal output via the first output terminal OUT1 may all be the high potential VGH1, while the potential of the second node N2 may be the low potential VGL1. That is, N1-1=VGH1, N1-2=VGH1, N2=VGL1, N3=VGH1, OUT1/CR=VGH1.

During the t4 phase, the potential of the first sub-node N1-1, the potential of the second sub-node N1-2, and the potential of the signal output via the first output terminal OUT1 may all be the high potential VGH1, while the potential of the second node N2 and the potential of the third node N3 may both be the low potential VGL1. That is, N1-1=VGH1, N1-2=VGH1, N2=VGL1, N3=VGL1, OUT1/CR=VGH1.

It can be understood that the driving timing simulation diagram of the shift register unit shown in FIG. 13 can be similarly referenced to FIG. 22. The difference is that for the structure shown in FIG. 13 compared to FIG. 12, since the second power supply terminal V2 uses the pull-down power supply terminal VGLL capable of providing a lower-potential signal, the potential of the second node N2 can be pulled down to a lower potential.

Optionally, taking the circuit structure shown in FIG. 14 as an example, where the first potential is a low potential and the second potential is a high potential, FIG. 23 shows another driving timing simulation diagram of a shift register unit. Referring to FIG. 23, the shift register unit may execute four phases from t1 to t4.

During the t1 phase: the potential of the first clock signal provided by the first clock terminal CK may be a low potential, the potential of the second clock signal provided by the second clock terminal CB may be a high potential, and the potential of the input signal provided by the input terminal IN may be a low potential. Thus, the P-type first transistor T1 may be switched on. Consequently, the low-potential input signal from the input terminal IN may be transmitted to the first node N1 via the switched-on first transistor T1, causing the potential of the first node N1 to be a low potential. With the potential of the first node N1 at a low potential, the P-type second transistor T2 and P-type sixth transistor T6 may both be switched on, while the N-type third transistor T3 may be switched off. Consequently, the high-potential first power supply signal provided by the first power supply terminal V1 (i.e., the pull-up power supply terminal VGH) may be transmitted to the second node N2 and the third node N3 via the switched-on second transistor T2 and sixth transistor T6, respectively. With the potentials of both the second node N2 and the third node N3 at a high potential, the P-type fifth transistor T5 and P-type seventh transistor T7 may both be switched off, while the N-type fourth transistor T4 may be switched on. Consequently, the low-potential third power supply signal provided by the third power supply terminal V3 may be transmitted to the first output terminal OUT1 via the switched-on fourth transistor T4.

During the t2 phase: the potential of the first clock signal provided by the first clock terminal CK may be a high potential, the potential of the second clock signal provided by the second clock terminal CB may be a low potential, and the potential of the input signal provided by the input terminal IN may be a low potential. Thus, the P-type first transistor T1 may be switched off. Under the coupling effect of the first capacitor C1, the potential of the third node N3 may remain at a high potential. Additionally, the potential of the first node N1 may remain at a low potential, and the potential of the second node N2 may remain at a high potential. With the potential of the first node N1 remaining at a low potential, the P-type second transistor T2 and P-type sixth transistor T6 may both remain switched on, while the N-type third transistor T3 remains switched off. Thus, the high-potential first power supply signal provided by the first power supply terminal V1 may continue to be transmitted to the second node N2 and the third node N3 via the switched-on second transistor T2 and sixth transistor T6, respectively. With the potentials of both the second node N2 and the third node N3 remaining at a high potential, the P-type fifth transistor T5 and P-type seventh transistor T7 may both remain switched off, while the N-type fourth transistor T4 remains switched on. Consequently, the low-potential third power supply signal provided by the third power supply terminal V3 may continue to be transmitted to the first output terminal OUT1 via the switched-on fourth transistor T4.

During the t3 phase: the potential of the first clock signal provided by the first clock terminal CK may be a low potential, the potential of the second clock signal provided by the second clock terminal CB may be a high potential, and the potential of the input signal provided by the input terminal IN may be a high potential. Thus, the P-type first transistor T1 may be switched on. Consequently, the high-potential input signal from the input terminal IN may be transmitted to the first node N1 via the switched-on first transistor T1, causing the potential of the first node N1 to be a high potential. With the potential of the first node N1 at a high potential, the P-type second transistor T2 and P-type sixth transistor T6 may both be switched off, while the N-type third transistor T3 may be switched on. Consequently, the low-potential second power supply signal provided by the second power supply terminal V2 may be transmitted to the second node N2 via the switched-on third transistor T3. Additionally, under the coupling effect of the first capacitor C1, the potential of the third node N3 may remain at a high potential. With the potential of the second node N2 at a low potential and the potential of the third node N3 at a high potential, the P-type fifth transistor T5 may be switched on, while the P-type seventh transistor T7 and N-type fourth transistor T4 may both be switched off. Consequently, the high-potential first power supply signal provided by the first power supply terminal V1 may be transmitted to the first output terminal OUT1 via the switched-on fifth transistor T5.

During the t4 phase: the potential of the first clock signal provided by the first clock terminal CK may be a high potential, the potential of the second clock signal provided by the second clock terminal CB may be a low potential, and the potential of the input signal provided by the input terminal IN may be a high potential. Thus, the P-type first transistor T1 may be switched off. Under the coupling effect of the first capacitor C1, the potential of the third node N3 may change to a low potential. Additionally, the potential of the first node N1 may remain at a high potential. With the potential of the first node N1 at a high potential and the potential of the third node N3 at a low potential, the P-type second transistor T2 and P-type sixth transistor T6 may both remain switched off, while the N-type third transistor T3 remains switched on. Thus, the low-potential second power supply signal provided by the second power supply terminal V2 may continue to be transmitted to the second node N2 via the switched-on third transistor T3. With the potentials of both the second node N2 and the third node N3 at a low potential, the N-type fourth transistor T4 may be switched off, while the P-type seventh transistor T7 and P-type fifth transistor T5 may both be switched on. Thus, not only can the low-potential second clock signal provided by the second clock terminal CB be transmitted to the second node N2 via the switched-on seventh transistor T7, pulling down the second node N2 to a lower potential and ensuring the P-type fifth transistor T5 is fully switched on, but the high-potential first power supply signal provided by the first power supply terminal V1 can also continue to be reliably transmitted to the first output terminal OUT1 via the fully switched-on fifth transistor T5.

Optionally, assuming a low potential is VGL1 and a high potential is VGH1, it can be seen with reference to FIG. 23 that:

In a t1 phase, a potential of a first node N1 and a potential of a signal output via a first output terminal OUT1 may both be the low potential VGL1, while potentials of a second node N2 and a third node N3 may both be the high potential VGH1. That is, N1=VGL1, N2=VGH1, N3=VGH1, OUT1/CR=VGL1.

In a t2 phase, the potential of the first node N1 and the potential of the signal output via the first output terminal OUT1 may both be the low potential VGL1, while the potentials of the second node N2 and the third node N3 may both be the high potential VGH1. That is, N1=VGL1, N2=VGH1, N3=VGH1, OUT1/CR=VGL1.

In a t3 phase, the potential of the first node N1, the potential of the third node N3, and the potential of the signal output via the first output terminal OUT1 may all be the high potential VGH1, while the potential of the second node N2 may be the low potential VGL1. That is, N1=VGH1, N2=VGL1, N3=VGH1, OUT1/CR=VGH1.

In a t4 phase, the potential of the first node N1 and the potential of the signal output via the first output terminal OUT1 may both be the high potential VGH1, while the potentials of the second node N2 and the third node N3 may both be the low potential VGL1. That is, N1=VGH1, N2=VGL1, N3=VGL1, OUT1/CR=VGH1.

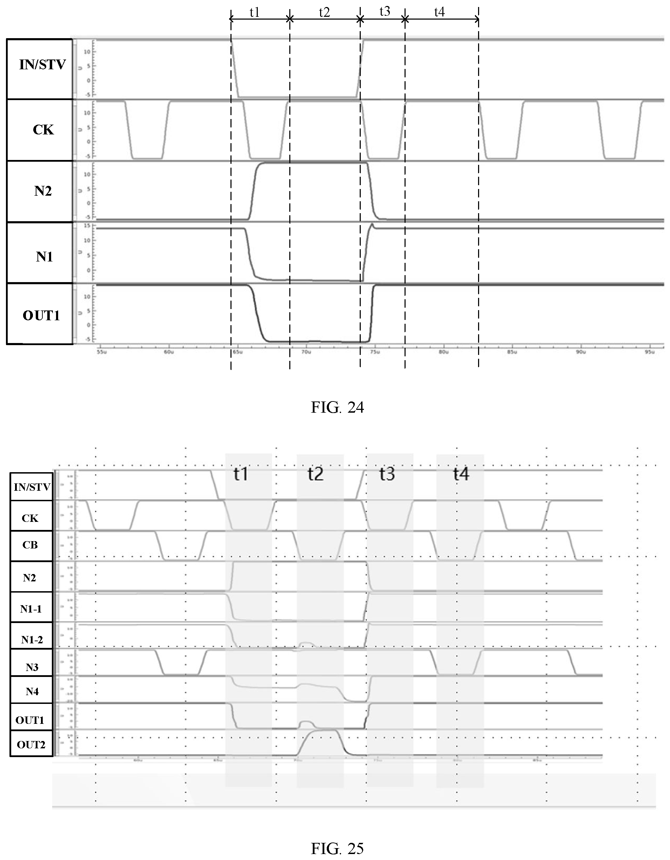

Optionally, taking the circuit structure shown in FIG. 15 as an example, where the first potential is the low potential and the second potential is the high potential, FIG. 24 shows a simulation diagram of driving timing for another shift register unit. With reference to FIG. 24, it can be seen that the shift register unit may execute four phases from t1 to t4.

In the t1 phase: a potential of a first clock signal provided by a first clock terminal CK may be the low potential, and a potential of an input signal provided by an input terminal IN may be the low potential. Thus, a P-type first transistor T1 may be turned on, thereby allowing the low-potential input signal provided by the input terminal IN to be transmitted to a first sub-node N1-1 via the turned-on first transistor T1, such that the potential of the first sub-node N1-1 becomes the low potential. Since a potential of a third power signal provided by a third power terminal V3 remains the low potential, a P-type eighth transistor T8 may be kept turned on. Thus, the low potential of the first sub-node N1-1 may be transmitted to a second sub-node N1-2 via the turned-on eighth transistor T8, such that the potential of the second sub-node N1-2 also becomes the low potential. When both the potential of the first sub-node N1-1 and the potential of the second sub-node N1-2 are controlled to be the low potential, a P-type second transistor T2 may be turned on and an N-type third transistor T3 may be turned off. Thereby, a high-potential first power signal provided by a first power terminal V1 may be transmitted to the second node N2 via the turned-on second transistor T2. When the potential of the second node N2 is controlled to be the high potential, a P-type fifth transistor T5 may be turned off and an N-type fourth transistor T4 may be turned on. Thus, the low-potential third power signal provided by the third power terminal V3 may be transmitted to the first output terminal OUT1 via the turned-on fourth transistor T4.

In the t2 phase: the potential of the first clock signal provided by the first clock terminal CK may be the high potential, and the potential of the input signal provided by the input terminal IN may be the low potential. Thus, the P-type first transistor T1 may be turned off. Additionally, the potentials of the first sub-node N1-1 and the second sub-node N1-2 may be kept at the low potential, and the potential of the second node N2 may be kept at the high potential. When the potentials of the first sub-node N1-1 and the second sub-node N1-2 remain the low potential, the P-type second transistor T2 may be kept turned on, and the N-type third transistor T3 may be kept turned off. Thus, the high-potential first power signal provided by the first power terminal V1 may continue to be transmitted to the second node N2 via the turned-on second transistor T2. When the potential of the second node N2 is kept at the high potential, the P-type fifth transistor T5 may be kept turned off, and the N-type fourth transistor T4 may be kept turned on. Thereby, the low-potential third power signal provided by the third power terminal V3 may continue to be transmitted to the first output terminal OUT1 via the turned-on fourth transistor T4.

In the t3 phase: the potential of the first clock signal provided by the first clock terminal CK may be the low potential, and the potential of the input signal provided by the input terminal IN may be the high potential. Thus, the P-type first transistor T1 may be turned on. Thereby, the high-potential input signal provided by the input terminal IN may be transmitted to the first sub-node N1-1 via the turned-on first transistor T1, such that the potential of the first sub-node N1-1 becomes the high potential. Since the eighth transistor T8 remains turned on, the high potential of the first sub-node N1-1 may be transmitted to the second sub-node N1-2 via the turned-on eighth transistor T8, such that the potential of the second sub-node N1-2 also becomes the high potential. When both the potential of the first sub-node N1-1 and the potential of the second sub-node N1-2 are controlled to be the high potential, the P-type second transistor T2 may be turned off, and the N-type third transistor T3 may be turned on. Thus, a low-potential second power signal provided by a second power terminal V2 may be transmitted to the second node N2 via the turned-on third transistor T3. When the potential of the second node N2 is controlled to be the low potential, the P-type fifth transistor T5 may be turned on, and the N-type fourth transistor T4 may be turned off. Thereby, the high-potential first power signal provided by the first power terminal V1 may be transmitted to the first output terminal OUT1 via the turned-on fifth transistor T5.

In the t4 phase: the potential of the first clock signal provided by the first clock terminal CK may be the high potential, and the potential of the input signal provided by the input terminal IN may be the high potential. Thus, the P-type first transistor T1 may be turned off. Additionally, the potentials of the first sub-node N1-1 and the second sub-node N1-2 may be kept at the high potential, and the potential of the second node N2 may be kept at the low potential. When the potentials of the first sub-node N1-1 and the second sub-node N1-2 are kept at the high potential, the P-type second transistor T2 may be kept turned off, and the N-type third transistor T3 may be kept turned on. Thus, the low-potential second power signal provided by the second power terminal V2 may be transmitted to the second node N2 via the turned-on third transistor T3. When the potential of the second node N2 is the low potential, the N-type fourth transistor T4 may be kept turned off, and the P-type fifth transistor T5 may be kept turned on. Thus, the high-potential first power signal provided by the first power terminal V1 may continue to be transmitted to the first output terminal OUT1 via the turned-on fifth transistor T5.

Optionally, assuming the low potential is VGL1 and the high potential is VGH1, it can be seen with reference to FIG. 24 that:

In the t1 phase, potentials of the first sub-node N1-1 and the second sub-node N1-2, and a potential of a signal output via the first output terminal OUT1 may all be the low potential VGL1, while a potential of the second node N2 may be the high potential VGH1. That is, N1-1=VGL1, N1-2=VGL1, N2=VGH1, OUT1/CR=VGL1.

In the t2 phase, the potentials of the first sub-node N1-1 and the second sub-node N1-2, and the potential of the signal output via the first output terminal OUT1 may all be the low potential VGL1, while the potential of the second node N2 may be the high potential VGH1. That is, N1-1=VGL1, N1-2=VGL1, N2=VGH1, OUT1/CR=VGL1.

In the t3 phase, the potentials of the first sub-node N1-1 and the second sub-node N1-2, and the potential of the signal output via the first output terminal OUT1 may all be the high potential VGH1, while the potential of the second node N2 may be the low potential VGL1. That is, N1-1=VGH1, N1-2=VGH1, N2=VGL1, OUT1/CR=VGH1.

In the t4 phase, the potentials of the first sub-node N1-1 and the second sub-node N1-2, and the potential of the signal output via the first output terminal OUT1 may all be the high potential VGH1, while the potential of the second node N2 may be the low potential VGL1. That is, N1-1=VGH1, N1-2=VGH1, N2=VGL1, OUT1/CR=VGH1.

Optionally, taking the circuit structure shown in FIG. 16 as an example, where the first potential is the low potential and the second potential is the high potential, FIG. 25 shows a simulation diagram of driving timing for another shift register unit. With reference to FIG. 25, it can be seen that the shift register unit may execute four phases from t1 to t4.

Since FIG. 16 further shows a shift register unit including a second output circuit 06 based on the structure shown in FIG. 12, a method for controlling the first output terminal OUT1 in FIG. 16 may refer to the above description related to FIG. 22, and details are not repeated herein. Additionally, for the structure shown in FIG. 16, its driving principle further includes:

In the t1 and t2 phases: the potential of the signal output via the first output terminal OUT1 is the low potential, and the potential of the second sub-node N1-2 is the low potential. Moreover, since a potential of a third power signal provided by the third power terminal V3 remains the low potential, a P-type eleventh transistor T11 may be kept turned on. Thereby, the low-potential signal output via the first output terminal OUT1 may be transmitted to a fourth node N4 via the turned-on eleventh transistor T11, such that the potential of the fourth node N4 also becomes the low potential. Thus, a P-type ninth transistor T9 may be turned on. Since a second target node N02 is shared with the second sub-node N1-2, the potential of the second target node N02 is also the low potential at this time. Thus, an N-type tenth transistor T10 may be turned off. Thereby, a third clock signal provided by a third clock terminal NCK may be transmitted to a second output terminal OUT2 via the turned-on ninth transistor T9. Based on the above description, the potential of the third clock signal is exactly opposite to a potential of a second clock signal in the same period. Since in the t1 phase, the potential of the second clock signal is the high potential, the potential of the third clock signal is the low potential. Correspondingly, in the t1 phase, the potential of the signal output via the second output terminal OUT2 is the low potential. Since in the t2 phase, the potential of the second clock signal is the low potential, the potential of the third clock signal is the high potential. Correspondingly, in the t2 phase, the potential of the signal output via the second output terminal OUT2 is the high potential.

The difference is that in the t2 phase relative to the t1 phase, since the potential of the second clock signal is the high potential, the potential of the third clock signal is the high potential. Thus, under the coupling effect of a fourth capacitor C4, the potential of the fourth node N4 is easily pulled toward an opposite potential, causing the potential of the signal output via the first output terminal OUT1 to fluctuate to the opposite potential and impairing reliable turning-on of the ninth transistor T9.

In the t3 and t4 phases: the potential of the signal output via the first output terminal OUT1 is the high potential, and the potential of the second sub-node N1-2 is the high potential. Additionally, since the eleventh transistor T11 remains turned on, the high-potential signal output via the first output terminal OUT1 may be transmitted to the fourth node N4 via the turned-on eleventh transistor T11, such that the potential of the fourth node N4 also becomes the high potential. Thus, the P-type ninth transistor T9 may be turned off. Since the second target node N02 is shared with the second sub-node N1-2, the potential of the second target node N02 is also the high potential at this time. Thus, the N-type tenth transistor T10 may be turned on. Thereby, a low-potential fourth power signal provided by a fourth power terminal V4 (e.g., a pull-down power terminal VGL) may be transmitted to the second output terminal OUT2 via the turned-on tenth transistor T10.

Optionally, assuming the low potential is VGL1 and the high potential is VGH1, it can be seen with reference to FIG. 25 that:

In the t1 phase, potentials of the first sub-node N1-1 and the second sub-node N1-2, a potential of the fourth node N4, the potential of the signal output via the first output terminal OUT1, and a potential of a signal output via the second output terminal OUT2 may all be the low potential VGL1, while potentials of the second node N2 and the third node N3 may both be the high potential VGH1. That is, N1-1=VGL1, N1-2=VGL1, N2=VGH1, N3=VGH1, N4=VGL1, OUT1/CR=VGL1, OUT2=VGL1.

In the t2 phase, the potentials of the first sub-node N1-1 and the second sub-node N1-2, the potential of the fourth node N4, and the potential of the signal output via the first output terminal OUT1 may all be the low potential VGL1, while the potentials of the second node N2 and the third node N3, and the potential of the signal output via the second output terminal OUT2 may all be the high potential VGH1. That is, N1-1=VGL1, N1-2=VGL1, N2=VGH1, N3=VGH1, OUT1/CR=VGL1, OUT2=VGH1.

In the t3 phase, the potentials of the first sub-node N1-1 and the second sub-node N1-2, the potential of the third node N3, the potential of the fourth node N4, and the potential of the signal output via the first output terminal OUT1 may all be the high potential VGH1, while the potential of the second node N2 and the potential of the signal output via the second output terminal OUT2 may both be the low potential VGL1. That is, N1-1=VGH1, N1-2=VGH1, N2=VGL1, N3=VGH1, OUT1/CR=VGH1, OUT2=VGL1.

In the t4 phase, the potentials of the first sub-node N1-1 and the second sub-node N1-2, the potential of the fourth node N4, and the potential of the signal output via the first output terminal OUT1 may all be the high potential VGH1, while the potentials of the second node N2 and the third node N3, and the potential of the signal output via the second output terminal OUT2 may all be the low potential VGL1. That is, N1-1=VGH1, N1-2=VGH1, N2=VGL1, N3=VGL1, OUT1/CR=VGH1, OUT2=VGL1.

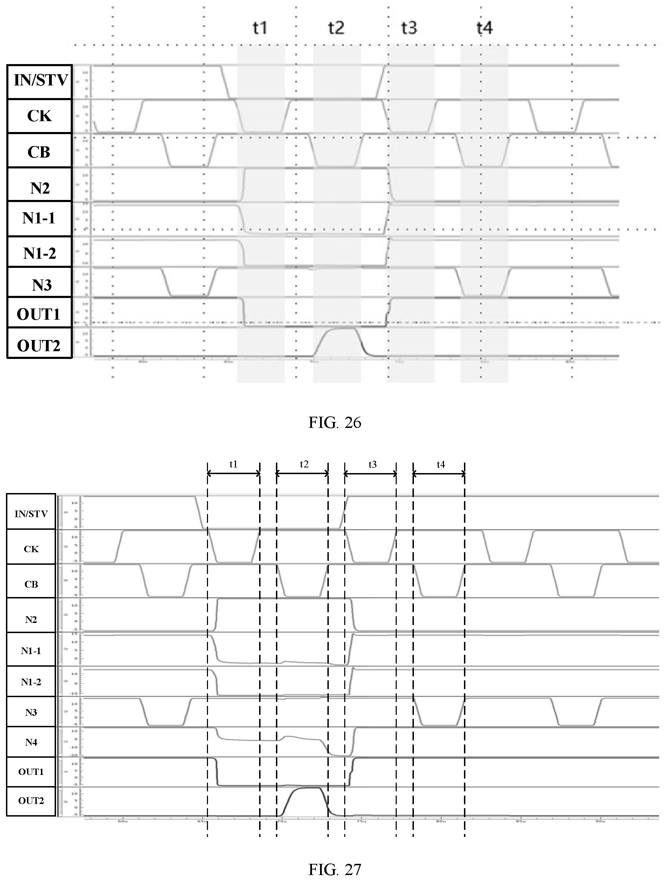

Optionally, taking the circuit structure shown in FIG. 17 as an example, where the first potential is the low potential and the second potential is the high potential, FIG. 26 shows a simulation diagram of driving timing for another shift register unit. With reference to FIG. 26, it can be seen that the shift register unit may execute four phases from t1 to t4.

Since FIG. 17 further shows a shift register unit including a second output circuit 06 based on the structure shown in FIG. 12, a method for controlling the first output terminal OUT1 in FIG. 17 may refer to the above description related to FIG. 22, and details are not repeated herein. Additionally, for the structure shown in FIG. 17, its driving principle further includes:

In the t1 phase: the potential of the signal output via the first output terminal OUT1 is the low potential, and the potential of the second node N2 is the high potential. Moreover, since the potential of the third power signal provided by the third power terminal V3 remains the low potential, the P-type eleventh transistor T11 may be kept turned on. Thereby, the low-potential signal output via the first output terminal OUT1 may be transmitted to the fourth node N4 via the turned-on eleventh transistor T11, such that the potential of the fourth node N4 also becomes the low potential. Thus, the P-type ninth transistor T9 may be turned on. Since the second target node N02 is shared with the second node N2, the potential of the second target node N02 is the high potential at this time. Thus, the N-type tenth transistor T10 may be turned on. Thereby, the third clock signal provided by the third clock terminal NCK may be transmitted to the second output terminal OUT2 via the turned-on ninth transistor T9, and the low-potential fourth power signal provided by the fourth power terminal V4 may also be transmitted to the second output terminal OUT2 via the turned-on tenth transistor T10. Based on the above description, since in the t1 phase, the potential of the third clock signal is the low potential, the low-potential signal may be reliably output via the second output terminal OUT2 at this time.

In the t2 phase: the potential of the signal output via the first output terminal OUT1 is the low potential, and the potential of the second node N2 is the high potential. Additionally, since the eleventh transistor T11 remains turned on, the low-potential signal output via the first output terminal OUT1 may be transmitted to the fourth node N4 via the turned-on eleventh transistor T11, such that the potential of the fourth node N4 also becomes the low potential. Furthermore, under the coupling effect of the fourth capacitor C4, the potential of the fourth node N4 may be further pulled down to a lower potential based on the low-potential signal output via the second output terminal OUT2. Thus, although the potential of the second target node N02 shared with the second node N2 is also the high potential, the P-type ninth transistor T9 can be reliably turned on relative to the N-type tenth transistor T10. Thereby, the third clock signal provided by the third clock terminal NCK may be transmitted to the second output terminal OUT2 via the turned-on ninth transistor T9. Based on the foregoing description, since the potential of the third clock signal is the high potential in the t2 phase, a high-potential signal can be reliably output via the second output terminal OUT2 at this time.

In the t3 and t4 phases: the potential of the signal output via the first output terminal OUT1 is the high potential, and the potential of the second node N2 is the low potential. Moreover, since the eleventh transistor T11 remains turned on, the high-potential signal output via the first output terminal OUT1 may be transmitted to the fourth node N4 via the turned-on eleventh transistor T11, such that the potential of the fourth node N4 also becomes the high potential. Thus, the P-type ninth transistor T9 may be turned off. Since the second target node N02 is shared with the second node N2, the potential of the second target node N02 is also the low potential at this time. Thus, the N-type tenth transistor T10 may be turned off. At this point, as previously recorded, the second output terminal OUT2 may be in a floating state. However, in any phase from t1 to t4, under the coupling effect of the fourth capacitor C4, the potential of the fourth node N4 can be further adjusted to a required lower or higher potential based on the signal output via the second output terminal OUT2, rather than to an opposite potential. This resolves the issue in the structure shown in FIG. 16 where the potential of the signal output via the first output terminal OUT1 fluctuates oppositely due to coupling effects.

Optionally, assuming the low potential is VGL1 and the high potential is VGH1, it can be seen with reference to FIG. 26 that:

In the t1 phase, potentials of the first sub-node N1-1, the second sub-node N1-2, the fourth node N4, the signal output via the first output terminal OUT1, and the signal output via the second output terminal OUT2 may all be the low potential VGL1, while potentials of the second node N2 and the third node N3 may both be the high potential VGH1. That is, N1-1=VGL1, N1-2=VGL1, N2=VGH1, N3=VGH1, N4=VGL1, OUT1/CR=VGL1, OUT2=VGL1.

In the t2 phase, potentials of the first sub-node N1-1, the second sub-node N1-2, the fourth node N4, and the signal output via the first output terminal OUT1 may all be the low potential VGL1, while potentials of the second node N2, the third node N3, and the signal output via the second output terminal OUT2 may all be the high potential VGH1. That is, N1-1=VGL1, N1-2=VGL1, N2=VGH1, N3=VGH1, OUT1/CR=VGL1, OUT2=VGH1.

In the t3 phase, potentials of the first sub-node N1-1, the second sub-node N1-2, the third node N3, the fourth node N4, and the signal output via the first output terminal OUT1 may all be the high potential VGH1, while the potential of the second node N2 may be the low potential VGL1. That is, N1-1=VGH1, N1-2=VGH1, N2=VGL1, N3=VGH1, OUT1/CR=VGH1. The second output terminal OUT2 is in a floating state.

In the t4 phase, potentials of the first sub-node N1-1, the second sub-node N1-2, the fourth node N4, and the signal output via the first output terminal OUT1 may all be the high potential VGH1, while potentials of the second node N2 and the third node N3 may both be the low potential VGL1. That is, N1-1=VGH1, N1-2=VGH1, N2=VGL1, N3=VGL1, OUT1/CR=VGH1. The second output terminal OUT2 is in a floating state.

Optionally, taking the circuit structure shown in FIG. 18 as an example, where the first potential is the low potential and the second potential is the high potential, FIG. 27 shows a simulation diagram of driving timing for another shift register unit. With reference to FIG. 27, it can be seen that the shift register unit may execute four phases from t1 to t4.

Since FIG. 18 further shows a shift register unit including a second output circuit 06 based on the structure shown in FIG. 12, a method for controlling the first output terminal OUT1 in FIG. 18 may refer to the above description related to FIG. 22, and details are not repeated herein. Additionally, for the structure shown in FIG. 18, its driving principle further includes:

In the t1 and t2 phases: the potential of the signal output via the first output terminal OUT1 is the low potential, and the potential of the second sub-node N1-2 is the low potential. Moreover, since the potential of the third power signal provided by the third power terminal V3 remains the low potential, the P-type eleventh transistor T11 may be kept turned on. Thereby, the low-potential signal output via the first output terminal OUT1 may be transmitted to the fourth node N4 via the turned-on eleventh transistor T11, such that the potential of the fourth node N4 also becomes the low potential. Thus, the P-type ninth transistor T9 may be turned on. Since the second target node N02 is shared with the second sub-node N1-2, the potential of the second target node N02 is also the low potential at this time. Thus, the N-type tenth transistor T10 may be turned off. Thereby, the third clock signal provided by the third clock terminal NCK may be transmitted to the second output terminal OUT2 via the turned-on ninth transistor T9. Based on the above description, since in the t1 phase, the potential of the third clock signal is the low potential, the potential of the signal output via the second output terminal OUT2 in the t1 phase is the low potential. Since in the t2 phase, the potential of the third clock signal is the high potential, the potential of the signal output via the second output terminal OUT2 in the t2 phase is the high potential.

In the t3 and t4 phases: the potential of the signal output via the first output terminal OUT1 is the high potential, and the potential of the second sub-node N1-2 is the high potential. Additionally, since the eleventh transistor T11 remains turned on, the high-potential signal output via the first output terminal OUT1 may be transmitted to the fourth node N4 via the turned-on eleventh transistor T11, such that the potential of the fourth node N4 also becomes the high potential. Thus, the P-type ninth transistor T9 may be turned off. Since the second target node N02 is shared with the second sub-node N1-2, the potential of the second target node N02 is also the high potential at this time. Thus, the N-type tenth transistor T10 may be turned on. Thereby, the low-potential fourth power signal provided by the fourth power terminal V4 may be transmitted to the second output terminal OUT2 via the turned-on tenth transistor T10.

This not only resolves the issue in the structure shown in FIG. 17 where the second output terminal OUT2 is in a floating state during the t3 and t4 phases, but also addresses the problem in the structure shown in FIG. 16 where the potential of the signal output via the first output terminal OUT1 fluctuates oppositely due to coupling effects. This is because in any phase from t1 to t4, under the coupling effect of the fourth capacitor C4, the potential of the fourth node N4 can be further adjusted to a required lower or higher potential based on the signal output via the second output terminal OUT2, rather than to an opposite potential.

Optionally, assuming the low potential is VGL1 and the high potential is VGH1, it can be seen with reference to FIG. 27 that:

In the t1 phase, potentials of the first sub-node N1-1, the second sub-node N1-2, the fourth node N4, the signal output via the first output terminal OUT1, and the signal output via the second output terminal OUT2 may all be the low potential VGL1, while the potential of the second node N2 may be the high potential VGH1. That is, N1-1=VGL1, N1-2=VGL1, N2=VGH1, N4=VGL1, OUT1/CR=VGL1, OUT2=VGL1.

In the t2 phase, potentials of the first sub-node N1-1, the second sub-node N1-2, the fourth node N4, and the signal output via the first output terminal OUT1 may all be the low potential VGL1, while potentials of the second node N2 and the signal output via the second output terminal OUT2 may both be the high potential VGH1. That is, N1-1=VGL1, N1-2=VGL1, N2=VGH1, OUT1/CR=VGL1, OUT2=VGH1.

In the t3 phase, potentials of the first sub-node N1-1, the second sub-node N1-2, the third node N3, the fourth node N4, and the signal output via the first output terminal OUT1 may all be the high potential VGH1, while potentials of the second node N2 and the signal output via the second output terminal OUT2 may both be the low potential VGL1. That is, N1-1=VGH1, N1-2=VGH1, N2=VGL1, N3=VGH1, OUT1/CR=VGH1, OUT2=VGL1.

In the t4 phase, potentials of the first sub-node N1-1, the second sub-node N1-2, the fourth node N4, and the signal output via the first output terminal OUT1 may all be the high potential VGH1, while potentials of the second node N2, the third node N3, and the signal output via the second output terminal OUT2 may all be the low potential VGL1. That is, N1-1=VGH1, N1-2=VGH1, N2=VGL1, N3=VGL1, OUT1/CR=VGH1, OUT2=VGL1.

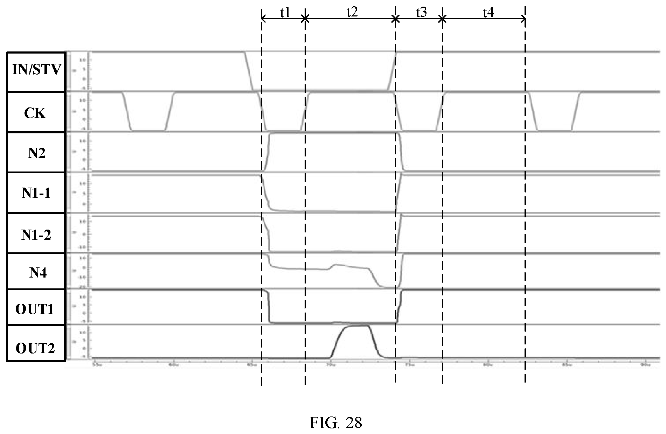

Optionally, taking the circuit structure shown in FIG. 19 as an example, where the first potential is the low potential and the second potential is the high potential, FIG. 28 shows a simulation diagram of driving timing for another shift register unit. With reference to FIG. 28, it can be seen that the shift register unit may execute four phases from t1 to t4.

Since FIG. 19 further shows a shift register unit including a second output circuit 06 based on the structure shown in FIG. 15 combined with the structure of the first output circuit 03 shown in FIG. 12, a method for controlling the first output terminal OUT1 in FIG. 19 may refer to the above descriptions related to FIGS. 22 and 24, and details are not repeated herein. Additionally, for the structure shown in FIG. 19, its driving principle further includes:

In the t1 and t2 phases: the potential of the signal output via the first output terminal OUT1 is the low potential, and the potential of the second sub-node N1-2 is the low potential. Moreover, since the potential of the third power signal provided by the third power terminal V3 remains the low potential, the P-type eleventh transistor T11 may be kept turned on. Thereby, the low-potential signal output via the first output terminal OUT1 may be transmitted to the fourth node N4 via the turned-on eleventh transistor T11, such that the potential of the fourth node N4 also becomes the low potential. Thus, the P-type ninth transistor T9 may be turned on. Since the second target node N02 is shared with the second sub-node N1-2, the potential of the second target node N02 is also the low potential at this time. Thus, the N-type tenth transistor T10 may be turned off. Thereby, the third clock signal provided by the third clock terminal NCK may be transmitted to the second output terminal OUT2 via the turned-on ninth transistor T9. Based on the above description, since in the t1 phase, the potential of the third clock signal is the low potential, the potential of the signal output via the second output terminal OUT2 in the t1 phase is the low potential. Since in the t2 phase, the potential of the third clock signal is the high potential, the potential of the signal output via the second output terminal OUT2 in the t2 phase is the high potential.

In the t3 and t4 phases: the potential of the signal output via the first output terminal OUT1 is the high potential, and the potential of the second sub-node N1-2 is the high potential. Additionally, since the eleventh transistor T11 remains turned on, the high-potential signal output via the first output terminal OUT1 may be transmitted to the fourth node N4 via the turned-on eleventh transistor T11, such that the potential of the fourth node N4 also becomes the high potential. Thus, the P-type ninth transistor T9 may be turned off. Since the second target node N02 is shared with the second sub-node N1-2, the potential of the second target node N02 is also the high potential at this time. Thus, the N-type tenth transistor T10 may be turned on. Thereby, the low-potential fourth power signal provided by the fourth power terminal V4 may be transmitted to the second output terminal OUT2 via the turned-on tenth transistor T10.

Optionally, assuming the low potential is VGL1 and the high potential is VGH1, it can be seen with reference to FIG. 28 that:

In the t1 phase, potentials of the first sub-node N1-1, the second sub-node N1-2, the fourth node N4, the signal output via the first output terminal OUT1, and the signal output via the second output terminal OUT2 may all be the low potential VGL1, while the potential of the second node N2 may be the high potential VGH1. That is, N1-1=VGL1, N1-2=VGL1, N2=VGH1, N4=VGL1, OUT1/CR=VGL1, OUT2=VGL1.

In the t2 phase, potentials of the first sub-node N1-1, the second sub-node N1-2, the fourth node N4, and the signal output via the first output terminal OUT1 may all be the low potential VGL1, while potentials of the second node N2 and the signal output via the second output terminal OUT2 may both be the high potential VGH1. That is, N1-1=VGL1, N1-2=VGL1, N2=VGH1, OUT1/CR=VGL1, OUT2=VGH1.

In the t3 phase, potentials of the first sub-node N1-1, the second sub-node N1-2, the fourth node N4, and the signal output via the first output terminal OUT1 may all be the high potential VGH1, while potentials of the second node N2 and the signal output via the second output terminal OUT2 may both be the low potential VGL1. That is, N1-1=VGH1, N1-2=VGH1, N2=VGL1, OUT1/CR=VGH1, OUT2=VGL1.

In the t4 phase, potentials of the first sub-node N1-1, the second sub-node N1-2, the fourth node N4, and the signal output via the first output terminal OUT1 may all be the high potential VGH1, while potentials of the second node N2 and the signal output via the second output terminal OUT2 may both be the low potential VGL1. That is, N1-1=VGH1, N1-2=VGH1, N2=VGL1, OUT1/CR=VGH1, OUT2=VGL1.

Furthermore, combining FIGS. 22, 23, and 25-27, for structures where the shift register unit is connected to two clock terminals - the first clock terminal CK and the second clock terminal CB - an interval may exist between any two adjacent phases from t1 to t4 (see labels in FIG. 22). During these intervals, potentials of both the first clock signal provided by CK and the second clock signal provided by CB may be at the high potential. This allows the potential of the third node N3 to be pulled to the high potential under the coupling effect of the first capacitor C1. Consequently, both the P-type first transistor T1 and the P-type seventh transistor T7 may be turned off. Under this condition, potentials of the first node N1 and the second node N2 remain at levels matching the preceding phase adjacent to the interval. For example, during the interval between phases t1 and t2, the potential of N1 remains at the low potential from phase t1, and the potential of N2 remains at the high potential from phase t1. This ensures reliable signal output to the first output terminal OUT1 by the first output circuit 03 within the interval, thereby guaranteeing superior output stability for the shift register unit. Of course, in other embodiments, such intervals may not exist between adjacent phases.

It is understandable that the above illustrates driving principles for shift register units with partial circuit structures. Driving principles for other structural shift register units may be similarly deduced from the above descriptions, with no further elaboration.

Additionally, since this driving method achieves substantially identical technical effects to the shift register unit previously described, details of its technical effects are omitted for conciseness.

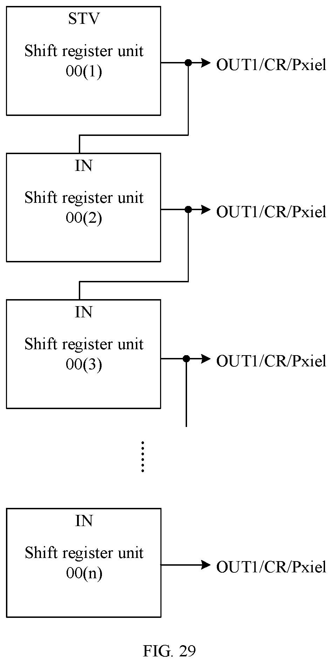

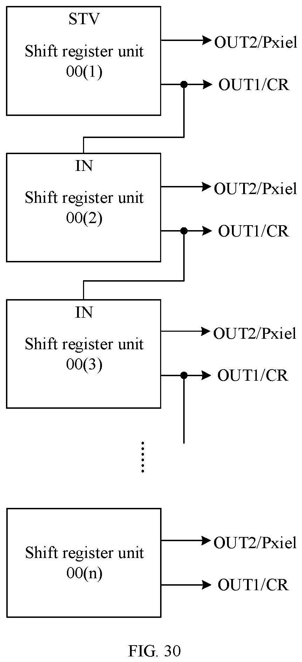

This embodiment also provides a display driving circuit. As shown in FIGS. 29 and 30, the display driving circuit includes at least two cascaded shift register units 00 as described above.

For example, FIGS. 29 and 30 both schematically show n cascaded shift register units 00(1), 00(2)...00(n), where n is an integer greater than 1.

FIG. 29 exemplifies a structure where the first output terminal OUT1 of each shift register unit 00 serves both as a cascade output terminal CR driving subsequent units and as a driving output terminal for pixels Pixel. In this configuration, each unit's first output terminal OUT1 connects to both pixels Pixel and the input terminal IN of subsequent cascaded units. For example, in FIG. 29, the first output terminal OUT1 of unit 00(1) connects to pixels Pixel and the input terminal IN of unit 00(2).

FIG. 30 exemplifies a structure (based on FIG. 16) where the first output terminal OUT1 serves solely as a cascade output terminal CR, while the second output terminal OUT2 drives pixels Pixel. Here, the first output terminal OUT1 of each unit connects to the input terminal IN of the next cascaded unit, and the second output terminal OUT2 connects to pixels Pixel. For example, in FIG. 30, the first output terminal OUT1 of unit 00(1) connects to the input terminal IN of unit 00(2).

As shown in FIGS. 29 and 30, the input terminal IN of the first shift register unit 00(1) connects to a start signal terminal STV to receive a start signal, initiating operation of the cascade. Each unit also connects to clock terminals (CK, CB) and power terminals (V1-V4), though not all are shown in FIGS. 29-30.

It is understandable that while FIGS. 29-30 show linear cascading (each unit connected only to adjacent units), other cascade topologies exist (e.g., connecting non-adjacent units). Furthermore, while units correspond to pixel rows in these figures, one unit may drive multiple pixel rows in other implementations.

Since this display driving circuit achieves substantially identical technical effects to the shift register unit described earlier, its technical effects are not repeated.

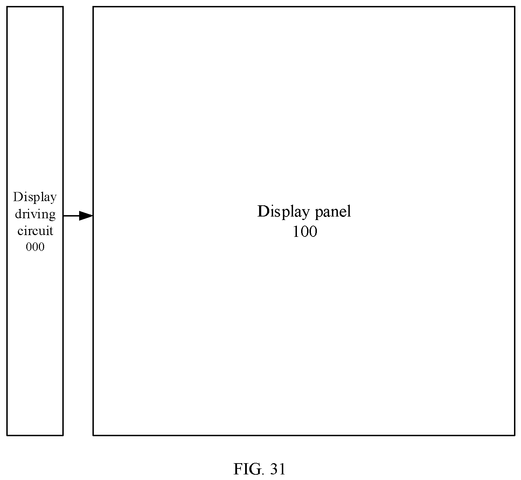

This embodiment further provides a display device. As shown in FIG. 31, the display device includes a display panel 100 and the display driving circuit 000 shown in FIG. 29 or FIG. 30.

The display panel 100 contains multiple pixels. The display driving circuit 000 connects to these pixels, transmitting display driving signals to drive pixel light emission (e.g., as a gate driving circuit providing gate driving signals).

Optionally, this display device may include: active-matrix organic light-emitting diode (AMOLED) displays, organic light-emitting diode (OLED) displays, liquid crystal displays (LCDs), or any other display product/component.

AMOLED displays feature low power consumption, wide operating temperatures, low cost, high contrast, wide viewing angles, broad color gamut, thin panels, and potential for flexible displays - positioning them as next-generation display leaders. OLED displays meet high-performance demands for indoor/outdoor lighting, wall decor, foldable e-paper, mobile phones, tablets, and wearable electronics.

Technical effects mirroring the shift register unit are not reiterated.

It should be noted that terminology in this embodiment is for explanatory purposes only and does not limit the application. Technical/scientific terms herein carry meanings understood by those skilled in the art unless otherwise defined.

Terms like "first," "second," or "third" denote component distinction - not order, quantity, or importance.

Similarly, "a" or "an" indicates existence of at least one item, not quantity limitation.

"Comprises" or "includes" implies the listed elements/items cover specified elements/items and equivalents, without excluding others.

Directional terms (e.g., "upper," "lower," "left," "right") denote relative positional relationships subject to change if absolute positions change. "Connected" or "coupled" means electrical connection.

"And/or" indicates three relationships: A alone, A and B together, or B alone. The symbol "/" denotes an "or" relationship between associated elements.

These embodiments are illustrative and not restrictive. Any modifications, equivalent substitutions, or improvements within the application's spirit and scope fall under its protection.

## Claims

1. A shift register unit, comprising:
a first input circuit, connected to a first clock terminal, an input terminal, and a first node, respectively, and configured to control switching on and off of a connection between the input terminal and the first node in response to a first clock signal provided by the first clock terminal;
a second input circuit, connected to the first node, a first power supply terminal, a second power supply terminal, and a second node, respectively, and configured to control switching on and off of a connection between the first power supply terminal and the second node and control switching on and off of a connection between the second power supply terminal and the second node in response to a potential of the first node, wherein the first power supply terminal and the second power supply terminal are switched on to the second node in different time periods, respectively; and
a first output circuit, connected to the second node, a first target node, the first power supply terminal, a third power supply terminal, and a first output terminal, respectively, and configured to control switching on and off of a connection between the first power supply terminal and the first output terminal in response to a potential of the second node, and control switching on and off of a connection between the third power supply terminal and the first output terminal in response to a potential of the first target node, wherein the first power supply terminal and the third power supply terminal are switched on to the first output terminal in different time periods, respectively; and wherein the first target node is shared as the first node or the second node.

2. The shift register unit according to claim 1, wherein the second power supply terminal is shared as the third power supply terminal;
or, the second power supply terminal and the third power supply terminal are independent of each other, and a potential of a second power supply signal provided by the second power supply terminal is less than a potential of a third power supply signal provided by the third power supply terminal.

3. The shift register unit according to claim 1 or 2, wherein the first input circuit comprises: a first transistor; wherein the first transistor is a P-type transistor; and
a gate of the first transistor is connected to the first clock terminal, a first electrode of the first transistor is connected to the input terminal, and a second electrode of the first transistor is connected to the first node.

4. The shift register unit according to any one of claims 1 to 3, wherein the second input circuit comprises: a second transistor and a third transistor; wherein the second transistor and the third transistor are a P-type transistor and an N-type transistor, respectively;
a gate of the second transistor is connected to the first node, a first electrode of the second transistor is connected to the first power supply terminal, and a second electrode of the second transistor is connected to the second node; and
a gate of the third transistor is connected to the first node, a first electrode of the third transistor is connected to the second power supply terminal, and a second electrode of the third transistor is connected to the second node.

5. The shift register unit according to any one of claims 1 to 4, wherein the first output circuit comprises: a fourth transistor and a fifth transistor; wherein the fourth transistor and the fifth transistor are both P-type transistors, or are an N-type transistor and a P-type transistor, respectively;
a gate of the fourth transistor is connected to the first target node, a first electrode of the fourth transistor is connected to the third power supply terminal, and a second electrode of the fourth transistor is connected to the first output terminal; and
a gate of the fifth transistor is connected to the second node, a first electrode of the fifth transistor is connected to the first power supply terminal, and a second electrode of the fifth transistor is connected to the first output terminal.

6. The shift register unit according to any one of claims 1 to 5, wherein the second input circuit is further connected to a third node, and is configured to control switching on and off of a connection between the first power supply terminal and the third node in response to the potential of the first node; and the shift register unit further comprises:
a third input circuit, connected to the third node, a second clock terminal, and the second node, respectively, and configured to control switching on and off of a connection between the second clock terminal and the second node in response to a potential of the third node, and regulate the potential of the third node based on a second clock signal provided by the second clock terminal.

7. The shift register unit according to claim 6, wherein the second input circuit further comprises: a sixth transistor; wherein the sixth transistor is a P-type transistor; and
a gate of the sixth transistor is connected to the first node, a first electrode of the sixth transistor is connected to the first power supply terminal, and a second electrode of the sixth transistor is connected to the third node.

8. The shift register unit according to claim 6 or 7, wherein the third input circuit comprises: a seventh transistor and a first capacitor; wherein the seventh transistor is a P-type transistor;
a gate of the seventh transistor is connected to the third node, a first electrode of the seventh transistor is connected to the second clock terminal, and a second electrode of the seventh transistor is connected to the second node; and
one terminal of the first capacitor is connected to the third node, and the other terminal of the first capacitor is connected to the second clock terminal.

9. The shift register unit according to any one of claims 6 to 8, wherein the first node comprises: a first sub-node and a second sub-node; and the shift register unit further comprises:
a first control circuit, connected to the third power supply terminal, the first sub-node, and the second sub-node, respectively, and configured to control switching on and off of a connection between the first sub-node and the second sub-node in response to a third power supply signal provided by the third power supply terminal;
and, the first input circuit is connected to the first sub-node, and configured to control switching on and off of a connection between the input terminal and the first sub-node in response to the first clock signal;
the second input circuit is connected to the first sub-node and the second sub-node, respectively, and configured to control switching on and off of a connection between the first power supply terminal and the second node and control switching on and off of a connection between the first power supply terminal and the third node in response to a potential of the first sub-node, and control switching on and off of a connection between the second power supply terminal and the second node in response to a potential of the second sub-node; or, in a case where the first target node is shared as the first node, the second input circuit is connected to the first sub-node, and configured to control switching on and off of a connection between the first power supply terminal and the second node, control switching on and off of a connection between the second power supply terminal and the second node, and control switching on and off of a connection between the first power supply terminal and the third node in response to the potential of the first sub-node; and the first output circuit is connected to the second sub-node, and configured to control switching on and off of a connection between the third power supply terminal and the first output terminal in response to the potential of the second sub-node.

10. The shift register unit according to claim 9, wherein the first control circuit comprises: an eighth transistor; wherein the eighth transistor is a P-type transistor; and
a gate of the eighth transistor is connected to the third power supply terminal, a first electrode of the eighth transistor is connected to the first sub-node, and a second electrode of the eighth transistor is connected to the second sub-node.

11. The shift register unit according to any one of claims 1 to 10, wherein the first output terminal is configured to be connected to an input terminal of another cascade-connected shift register unit and a pixel, respectively;
or, the first output terminal is configured to be connected to an input terminal of another cascade-connected shift register unit, and the shift register unit further comprises:
a second output circuit, connected to the first output terminal, a second target node, a third clock terminal, a fourth power supply terminal, and a second output terminal, respectively, and configured to control switching on and off of a connection between the third clock terminal and the second output terminal in response to a signal output via the first output terminal, and control switching on and off of a connection between the fourth power supply terminal and the second output terminal in response to a potential of the second target node, wherein the third clock terminal and the fourth power supply terminal are switched on to the second output terminal in different time periods, respectively; wherein the second output terminal is configured to be connected to a pixel; and the second target node is shared as the first node connected to the first output circuit or the second node connected to the first output circuit.

12. The shift register unit according to claim 11, wherein the fourth power supply terminal is shared as the third power supply terminal;
or, the fourth power supply terminal and the third power supply terminal are independent of each other, and a potential of a fourth power supply signal provided by the fourth power supply terminal is less than a potential of a third power supply signal provided by the third power supply terminal.

13. The shift register unit according to claim 11 or 12, wherein the second output circuit comprises: a ninth transistor and a tenth transistor; wherein the ninth transistor and the tenth transistor are a P-type transistor and an N-type transistor, respectively;
a gate of the ninth transistor is connected to the first output terminal, a first electrode of the ninth transistor is connected to the third clock terminal, and a second electrode of the ninth transistor is connected to the second output terminal; and
a gate of the tenth transistor is connected to the second target node, a first electrode of the tenth transistor is connected to the fourth power supply terminal, and a second electrode of the tenth transistor is connected to the second output terminal.

14. The shift register unit according to any one of claims 11 to 13, further comprising:
a second control circuit, connected between the first output terminal and the second output circuit, and further connected to the third power supply terminal, and configured to control switching on and off of a connection between the first output terminal and the second output circuit in response to a third power supply signal provided by the third power supply terminal.

15. The shift register unit according to claim 14, wherein the second control circuit comprises: an eleventh transistor; wherein the eleventh transistor is a P-type transistor; and
a gate of the eleventh transistor is connected to the third power supply terminal, a first electrode of the eleventh transistor is connected to the first output terminal, and a second electrode of the eleventh transistor is connected to the second output circuit.

16. The shift register unit according to claim 14 or 15, further comprising at least one circuit of:
a first potential regulation circuit, connected to the first target node and the first output terminal, respectively, and configured to regulate the potential of the first target node based on a signal output via the first output terminal, wherein the first target node is shared as the first node;
a second potential regulation circuit, connected to the second node and the first power supply terminal, respectively, and configured to regulate the potential of the second node based on a first power supply signal provided by the first power supply terminal; or
a third potential regulation circuit, connected to a target signal terminal and a connection node between the second control circuit and the second output circuit, respectively, and configured to regulate a potential of the connection node based on a signal provided by the target signal terminal; wherein, in a case where the second target node is shared as the first node, the target signal terminal is the third clock terminal or the second output terminal; and in a case where the second target node is shared as the second node, the target signal terminal is the second output terminal.

17. The shift register unit according to claim 16, wherein the first potential regulation circuit comprises a second capacitor; the second potential regulation circuit comprises a third capacitor; and the third potential regulation circuit comprises a fourth capacitor; wherein
one terminal of the second capacitor is connected to the first target node, and the other terminal of the second capacitor is connected to the first output terminal;
one terminal of the third capacitor is connected to the second node, and the other terminal of the third capacitor is connected to the first power supply terminal; and
one terminal of the fourth capacitor is connected to the connection node, and the other terminal of the fourth capacitor is connected to the target signal terminal.

18. A driving method of a shift register unit, for driving the shift register unit according to any one of claims 1 to 17; the method comprising:
during an input phase, controlling, by the first input circuit, a connection between the input terminal and the first node to be switched on in response to a first clock signal provided by the first clock terminal, controlling, by the second input circuit, a connection between the first power supply terminal and the second node to be switched on and a connection between the second power supply terminal and the second node to be switched off in response to a potential of the first node, and, controlling, by the first output circuit, a connection between the first power supply terminal and the first output terminal to be switched off in response to a potential of the second node, and a connection between the third power supply terminal and the first output terminal to be switched on in response to a potential of a first target node; wherein the first target node is shared as the first node or the second node; and
during an output phase, controlling, by the first input circuit, a connection between the input terminal and the first node to be switched on in response to the first clock signal, controlling, by the second input circuit, a connection between the first power supply terminal and the second node to be switched off and a connection between the second power supply terminal and the second node to be switched on in response to the potential of the first node, and, controlling, by the first output circuit, a connection between the first power supply terminal and the first output terminal to be switched on in response to the potential of the second node, and a connection between the third power supply terminal and the first output terminal to be switched off in response to the potential of the first target node.

19. The method according to claim 18, wherein the first output terminal is configured to be connected to an input terminal of another cascade-connected shift register unit and a pixel, respectively; or, the first output terminal is configured to be connected to an input terminal of another cascade-connected shift register unit, and the shift register unit further comprises: a second output circuit; and the method further comprises:
during the input phase, controlling, by the second output circuit, a connection between the third clock terminal and a second output terminal to be switched on in response to a signal output via the first output terminal, and a connection between a fourth power supply terminal and the second output terminal to be switched off in response to a potential of a second target node; wherein the second output terminal is configured to be connected to the pixel; and the second target node is shared as the first node connected to the first output circuit or the second node connected to the first output circuit; and
during the output phase, controlling, by the second output circuit, a connection between the third clock terminal and the second output terminal to be switched off in response to the signal output via the first output terminal, and a connection between the fourth power supply terminal and the second output terminal to be switched on in response to the potential of the second target node.

20. A display driving circuit, comprising: at least two cascade-connected shift register units according to any one of claims 1 to 17.

21. A display device, comprising: a display panel, and the display driving circuit according to claim 20; wherein
the display panel comprises a plurality of pixels, the display driving circuit is connected to the plurality of pixels, and the display driving circuit is configured to transmit display driving signals to the plurality of pixels to drive the plurality of pixels to emit light.
